# EUROPEAN PATENT APPLICATION

(11) **EP 4 394 846 A1**
(43) Date of publication of application: **03.07.2024**
(21) Application number: 22894633.1
(22) Date of filing: 02.11.2022

(54) **DISPLAY PANEL AND MANUFACTURING METHOD THEREFOR, AND ELECTRONIC DEVICE**

(30) Priority: 17.11.2021 CN 202111362915
(71) Applicant: Huawei Technologies Co., Ltd., Shenzhen, Guangdong 518129 (CN)
(72) Inventor: LAO, Xun, Shenzhen, Guangdong 518129 (CN); SHEN, Menghu, Shenzhen, Guangdong 518129 (CN); HAN, Haisu, Shenzhen, Guangdong 518129 (CN); LI, Xia, Shenzhen, Guangdong 518129 (CN); DAI, Xiaotao, Shenzhen, Guangdong 518129 (CN); XU, Yuling, Shenzhen, Guangdong 518129 (CN)
(74) Representative: Gill Jennings & Every LLP
(86) International application number: PCT/CN2022/129163
(87) International publication number: WO 2023/088096

(57) **Abstract**

Embodiments of this application relate to the field of display technologies and provide a display panel and a manufacturing method therefor, and an electronic device, to effectively avoid water vapor seeping and reduce a risk of packaging failure. The display panel includes: a hole, a transition region, and an image display region; a substrate; a display layer, located on a side of the substrate, where the display layer includes a cathode, and the cathode includes a first cathode portion located in the transition region; an isolation column, located on the side of the substrate and located in the transition region; and a first film layer, in contact with the isolation column and located on a side that is of the isolation column and that faces the substrate. The isolation column includes an insulation isolation portion. At least a part of a side wall of the insulation isolation portion is recessed toward an inside of the insulation isolation portion to form a groove. A surface of a side that is of the insulation isolation portion and that is away from the substrate is a first surface. A surface, in contact with the first film layer, of a side that is of the insulation isolation portion and that faces the substrate is a second surface. The first cathode portion extending on the first film layer is separated at the groove from the first cathode portion extending on the first surface.

## Description

This application claims priority to Chinese Patent Application No. 202111362915.3, filed with the China National Intellectual Property Administration on November 17, 2021 and entitled "DISPLAY PANEL AND MANUFACTURING METHOD THEREFOR, AND ELECTRONIC DEVICE", which is incorporated herein by reference in its entirety.

### TECHNICAL FIELD

This application relates to the field of display technologies, and more specifically, to a display panel and a manufacturing method therefor, and an electronic device.

### BACKGROUND

A hole-in-display design for a display panel has been a development trend in recent years. The display panel is provided with a hole in a display region, so that an optical component such as a camera can be disposed in the hole to avoid occupying space in a frame region. This design is an optimal solution for implementing a full-screen display while photographing effect and display effect are ensured.

For example, an organic light-emitting diode (Organic Light-Emitting Diode, OLED) display panel is provided with a hole in a display region. In this case, a cathode of a light-emitting component is separated at the hole, and water vapor in the hole is highly likely to seep into the display region along the cathode, affecting performance of a component in the display panel. Therefore, in the conventional technology, an isolation column is usually disposed around the hole, so that the cathode is separated at the isolation column, to cut off a path for water vapor seeping. However, the existing isolation column may put the display panel at risk of packaging failure, and consequently reliability of the panel is reduced.

### SUMMARY

In view of this, this application provides a display panel and a manufacturing method therefor, and an electronic device. An isolation column is configured to effectively avoid water vapor seeping, and further reduce a risk of packaging failure.

According to a first aspect, an embodiment of this application provides a display panel, including:
a hole, a transition region surrounding the hole, and an image display region surrounding the transition region;
a substrate;
a display layer, located on a side of the substrate, where the hole runs through at least the display layer, the display layer includes a cathode, and the cathode includes a first cathode portion located in the transition region;
an isolation column, located on the side of the substrate and located in the transition region; and
a first film layer, in contact with the isolation column and located on a side that is of the isolation column and that faces the substrate.

The isolation column includes an insulation isolation portion. At least a part of a side wall of the insulation isolation portion is recessed toward an inside of the insulation isolation portion to form a groove. A surface of a side that is of the insulation isolation portion and that is away from the substrate is a first surface. A surface, in contact with the first film layer, of a side that is of the insulation isolation portion and that faces the substrate is a second surface.

The first cathode portion extending on the first film layer is separated at the groove from the first cathode portion extending on the first surface.

In this embodiment of this application, the isolation column is provided with the insulation isolation portion that is in contact with the first film layer and that is provided with the groove. The groove is used as an isolation groove to separate two parts of the first cathode portion that respectively extend on the first film layer and the first surface. In this way, the first cathode portion forms a plurality of discontinuous parts. This effectively cuts off a path for water vapor seeping, and prevents water vapor in the hole from seeping into the image display region along the first cathode portion. In addition, based on an insulation characteristic of the insulation isolation portion, the two separated parts of the first cathode portion that respectively extend on the first film layer and the first surface are electrically insulated from each other. Besides, because the insulation isolation portion is in contact with the first film layer, two separated parts of the first cathode portion that extend on the first surface and that are located on two opposite sides of the insulation isolation portion are also electrically insulated from each other. In this case, the plurality of discontinuous parts formed by the first cathode portion are electrically insulated from each other, so that a path for current transmission is cut off. Even if the cathode in the image display region is energized, a current cannot flow along the first cathode portion toward a hole wall. As a result, no current is transmitted through metals in the transition region, and therefore, no electrochemical reaction condition is available. Even if a corrosive impurity is migrated to an edge of the isolation column, electricity and water vapor promote no electrochemical reaction. This avoids deformation of a packaging layer caused by metal corrosion and expansion, and therefore avoids a risk of packaging failure and improves packaging reliability of the display panel.

In addition, in this embodiment of this application, the groove of the isolation column is formed by the insulation isolation portion. Compared with a metal layer, the insulation layer has a larger thickness, and therefore has relatively high stability and is not easy to break. Therefore, a risk of failure of the groove in the isolation column can be effectively reduced.

In an implementation, the insulation isolation portion is of an integrated structure. To be specific, components of the insulation isolation portion are connected to each other and are integrated. In a process of the display panel, the insulation isolation portion is formed only through a single-step composition process. In this way, a process flow of the insulation isolation portion can be simplified. In addition, when the isolation column is subject to a common array process such as high-pressure water cleaning and a high-pressure air knife in a subsequent process, stability of the insulation isolation portion of the integrated structure is higher, and consequently, a phenomenon in which a film layer inside the insulation isolation portion is tilted or broken does not occur. This improves stability of the isolation column.

Further, the insulation isolation portion is an organic insulation layer. Affected by a current process capability, compared with an inorganic insulation layer, the organic insulation layer is more likely to form a relatively large film thickness. When the insulation isolation portion is the organic insulation layer, correspondingly, a height that is of the groove in the insulation isolation portion and that is in a direction perpendicular to a plane on which the substrate is located may also be set to a larger value. Subsequently, when the cathode is formed, it may be ensured, to a greater extent, that the first cathode portion is separated at the groove. It is effectively ensured that the first cathode portion is separated and electrically insulated from each other while process difficulty of forming the cathode is reduced.

In an implementation, the isolation column further includes a metal isolation portion. The metal isolation portion is located at the groove. A surface, furthest away from the substrate, of a side that is of the metal isolation portion and that is away from the substrate is a third surface, and the insulation isolation portion covers the third surface.

The metal isolation portion is disposed in the groove, and the groove of the insulation isolation portion may be filled by using the metal isolation portion. When the isolation column is subject to a common array process such as high-pressure water cleaning and a high-pressure air knife in a subsequent process, the insulation isolation portion is prevented from shaking greatly, and stability of the isolation column is improved. In addition, the insulation isolation portion covers the third surface of the metal isolation portion. Therefore, the top of the insulation isolation portion isolates the metal isolation portion from the first cathode portion extending on the first surface. Even if the first cathode portion extending on the first film layer is electrically connected to the metal isolation portion, the first cathode portion extending on the first film layer is still electrically insulated from the first cathode portion extending on the first surface, to ensure that a path for current transmission is cut off.

In an implementation, in a direction perpendicular to a plane on which the substrate is located, the groove includes a first side and a second side that are opposite to each other. The metal isolation portion includes a first metal portion and a second metal portion. The first metal portion is located on the first side of the groove. The second metal portion is located on the second side of the groove. There is a spacing between the first metal portion and the second metal portion.

In the foregoing structure, no other structure is filled between the first metal portion and the second metal portion. Therefore, it is easier to ensure that the first cathode portion is discontinuous at the groove. In addition, the first metal portion and the second metal portion are electrically insulated from each other. As a result, no conductive path is formed between the first metal portion and the second metal portion. This further improves reliability of cutting off a path for current transmission.

Further, the metal isolation portion includes a third metal portion. The third metal portion is located between the first metal portion and the second metal portion. The first metal portion and the second metal portion separately protrude from the third metal portion in a direction away from the inside of the insulation isolation portion.

When the metal isolation portion includes the third metal portion located between the first metal portion and the second metal portion, the metal isolation portion can more stably support the insulation isolation portion. This avoids shaking of the insulation isolation portion under an external force. In addition, the first metal portion and the second metal portion protrude from the third metal portion, which is equivalent to that a side wall of the third metal portion contracts inward to form a gap. The gap can also block the first cathode portion, so that the first cathode portion is discontinuously disposed at the gap. In addition, it should be noted that, although the first metal portion and the second metal portion may be electrically connected by using the third metal portion, the insulation isolation portion covers the third metal portion. Therefore, the insulation isolation portion can still electrically insulate the metal isolation portion from the first cathode portion extending on the first surface, so that the first cathode portion extending on the first film layer and the first cathode portion extending on the first surface are electrically insulated. This ensures that the separated parts of the first cathode portion are electrically insulated from each other.

In an implementation, the insulation isolation portion includes two grooves that are opposite to each other. The isolation column includes two metal isolation portions. The two metal isolation portions are respectively located in the two grooves.

The insulation isolation portion includes a first insulation portion and a second insulation portion. The first insulation portion is located between the two metal isolation portions. The second insulation portion covers a side wall of the first insulation portion and a surface of a side that is of the first insulation portion and that is away from the substrate. The second insulation portion further covers third surfaces of the two metal isolation portions.

In this way, the insulation isolation portion includes two film layers: the first insulation portion and the second insulation portion. A total thickness of the two insulation portions forms a thickness of the insulation isolation portion. The thickness of the two insulation portions is superposed, so that the total thickness of the insulation isolation portion is increased more easily. In this way, the insulation isolation portion has better film layer flatness and higher stability. Moreover, in addition to a surface of a side that is of the first insulation portion and that is away from the substrate, the second insulation portion further covers the side wall of the first insulation portion. A contact area between the two insulation portions is larger, and the two insulation portions are not easily detached under an external force.

Further, the first insulation portion is an organic insulation layer or an inorganic insulation layer, and the second insulation portion is an organic insulation layer or an inorganic insulation layer.

In an implementation, the display panel further includes a dam located in the transition region, and at least a part of isolation columns are located on a side that is of the dam and that is close to the hole.

The at least a part of isolation columns are located on the side that is of the dam and that is close to the hole, and the part of the isolation columns are relatively close to the hole, to ensure that the first cathode portions near edges of the hole are separated and electrically insulated from each other. This prevents, to a greater extent, water vapor in the hole from seeping inward along the first cathode portion, and improves water vapor isolation performance.

An embodiment of this application further provides a manufacturing method for a display panel, including:
providing a substrate, where the substrate includes a preset hole region, a transition region surrounding the preset hole region, and an image display region surrounding the transition region;
forming a first film layer in the preset hole region, the transition region, and the image display region of the substrate;
forming an isolation column on the first film layer, where the isolation column is located in the transition region, and the isolation column includes an insulation isolation portion; and recessing at least a part of a side wall of the insulation isolation portion toward an inside of the insulation isolation portion to form a groove, where a surface of a side that is of the insulation isolation portion and that is away from the substrate is a first surface, and a surface that is of the insulation isolation portion and that is in contact with the first film layer is a second surface;
forming a display layer in the preset hole region, the transition region, and the image display region of the substrate, where the display layer includes a cathode, the cathode includes a first cathode portion located in the transition region, and the first cathode portion extending on the first film layer is separated at the groove from the first cathode portion extending on the first surface; and
cutting the substrate, the first film layer, and the display layer along an edge of the preset hole region to form a hole.

The display panel is formed by using the foregoing method. The isolation column is provided with the insulation isolation portion that is in contact with the first film layer and that is provided with the groove, so that two parts of the first cathode portion that respectively extend on the first film layer and the first surface may be separated by using the groove, and a path for water vapor seeping can be effectively cut off. In addition, based on a design of the insulation isolation portion, the two parts of the first cathode portion that extend on the first surface and that are located on two opposite sides of the insulation isolation portion may also be electrically insulated from each other. Further, a plurality of discontinuous parts formed by the first cathode portion are electrically insulated from each other, and a path for current transmission in the first cathode portion is effectively cut off. In this way, an electrochemical reaction condition is eliminated, and metals in the transition region do not undergo an electrochemical reaction under promotion of a corrosive impurity. This avoids a risk of packaging failure caused by a crack due to deformation of a packaging layer.

In an implementation, the transition region includes a preset groove region, and after the forming a first film layer, the manufacturing method further includes: forming a sacrificial metal portion on the first film layer, where the sacrificial metal portion is located in the preset groove region.

A process of forming the insulation isolation portion on the first film layer, and recessing at least the part of the side wall of the insulation isolation portion toward the inside of the insulation isolation portion to form the groove includes:
forming the insulation isolation portion on the first film layer, where the insulation isolation portion covers the sacrificial metal portion; and
removing the sacrificial metal portion, so that a side wall that is of the insulation isolation portion and that is in contact with the sacrificial metal portion form the groove.

In the foregoing manufacturing process, the groove of the insulation isolation portion is formed by using the sacrificial metal portion. The sacrificial metal portion and an original metal layer in the panel may be formed through a same composition process. Therefore, no additional process is required. In addition, there is no need to add a device for performing side etching on an insulation layer. This reduces costs.

An embodiment of this application further provides an electronic device, including the foregoing display panel.

The electronic device includes the foregoing display panel. Therefore, the electronic device cannot only disconnect a cathode by using an isolation column, to cut off a path for water vapor seeping, but also electrically insulate separated cathodes from each other, to cut off a path for current transmission. This further avoids a risk of packaging failure caused by an electrochemical reaction between metals.

### BRIEF DESCRIPTION OF DRAWINGS

To describe the technical solutions in embodiments of this application or in the conventional technology more clearly, the following briefly describes the accompanying drawings used in describing embodiments or the conventional technology. It is clear that the accompanying drawings in the following descriptions show some embodiments of this application, and a person skilled in the art can still derive other accompanying drawings from these accompanying drawings without creative efforts.
FIG. 1 is a partial sectional view of a display panel in the conventional technology;
FIG. 2 is a schematic diagram of a structure of a protrusion formed by metal expansion in the conventional technology;
FIG. 3 is a top view of a display panel according to an embodiment of this application;
FIG. 4 is a sectional view of FIG. 3 in an A1-A2 direction;
FIG. 5 is a schematic diagram of a structure of an isolation column according to an embodiment of this application;
FIG. 6 is a schematic diagram of another structure of an isolation column according to an embodiment of this application;
FIG. 7 is a schematic diagram of a film layer structure of a display panel according to an embodiment of this application;
FIG. 8A and FIG. 8B are a flowchart of a process of a manufacturing method for an isolation column corresponding to FIG. 7;
FIG. 9 is a schematic diagram of still another structure of an isolation column according to an embodiment of this application;
FIG. 10 is a schematic diagram of another film layer structure of a display panel according to an embodiment of this application;
FIG. 11A to FIG. 11C are a flowchart of a process of a manufacturing method for an isolation column corresponding to FIG. 10;
FIG. 12 is a schematic diagram of yet another structure of an isolation column according to an embodiment of this application;
FIG. 13 is a schematic diagram of still another film layer structure of a display panel according to an embodiment of this application;
FIG. 14A to FIG. 14C are a flowchart of a process of a manufacturing method for an isolation column corresponding to FIG. 13;
FIG. 15 is a schematic diagram of still yet another structure of an isolation column according to an embodiment of this application;
FIG. 16 is a schematic diagram of yet another film layer structure of a display panel according to an embodiment of this application;
FIG. 17A and FIG. 17B are a flowchart of a process of a manufacturing method for an isolation column corresponding to FIG. 16;
FIG. 18 is a schematic diagram of still yet another film layer structure of a display panel according to an embodiment of this application;
FIG. 19A and FIG. 19B are a flowchart of a process of a manufacturing method for an isolation column corresponding to FIG. 18;
FIG. 20 is a schematic diagram of a further film layer structure of a display panel according to an embodiment of this application;
FIG. 21A and FIG. 21B are a flowchart of a process of a manufacturing method for an isolation column corresponding to FIG. 20;
FIG. 22 is a top view of an isolation column according to an embodiment of this application;
FIG. 23 is a sectional view of FIG. 22 in a B1-B2 direction;
FIG. 24 is another top view of an isolation column according to an embodiment of this application;
FIG. 25 is a sectional view of FIG. 24 in a C1-C2 direction;
FIG. 26 is a flowchart of a manufacturing method according to an embodiment of this application; and
FIG. 27 is a schematic diagram of a structure of an electronic device according to an embodiment of this application.

### DESCRIPTION OF EMBODIMENTS

To make the objectives, technical solutions, and advantages of embodiments of this application clearer, the following clearly and completely describes the technical solutions in embodiments of this application with reference to the accompanying drawings in embodiments of this application. It is clear that the described embodiments are merely some rather than all of embodiments of this application. All other embodiments obtained by a person skilled in the art based on embodiments of this application without creative efforts shall fall within the protection scope of this application.

Terms used in embodiments of this application are merely for the purpose of describing specific embodiments, but are not intended to limit this application. The terms "a", "said" and "the" of singular forms used in embodiments and the appended claims of this application are also intended to include plural forms, unless otherwise specified in the context clearly.

Before the technical solutions of this application are described, this application first specifically describes problems in the conventional technology.

For a display panel using a hole-in-display design, a display region of the display panel includes a hole region and an image display region. The hole region is configured to accommodate an optical component such as a camera. After each film layer of the display panel is manufactured, an edge of the hole region is cut to form a hole.

The display panel includes a plurality of light-emitting elements, and the plurality of light-emitting elements receive a same cathode voltage. Therefore, the display panel usually provides a cathode voltage for the light-emitting element by using a cathode made on an entire surface. In this case, after the edge of the hole region is cut to form the hole, the cathode is separated at the hole, and a side wall of the cathode is exposed at a hole wall, to provide a path for water vapor in the hole to seep into an inside of the display region from an inside of the hole. As a result, the water vapor seeps into an inside of the panel, and a component in the panel is adversely affected.

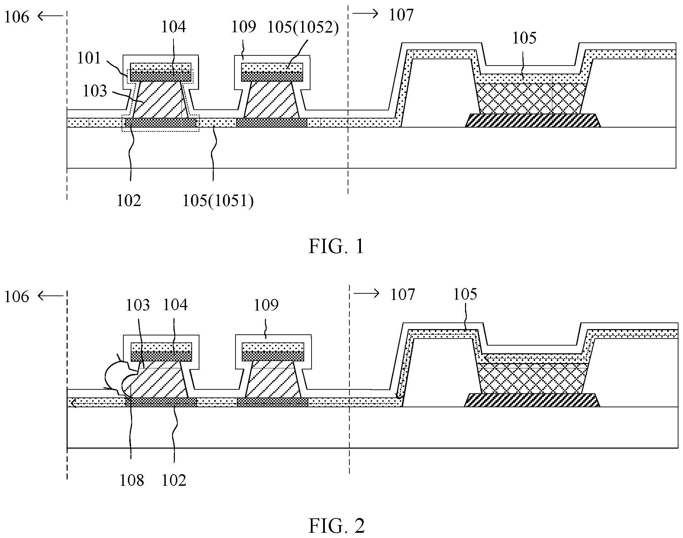

Therefore, in the conventional technology, an isolation column is usually disposed around the hole, so that the cathode is separated at the isolation column. FIG. 1 is a partial sectional view of a display panel in the conventional technology. As shown in FIG. 1, the display panel includes an isolation column 101, the isolation column 101 is of a metal structure, and the isolation column 101 includes a first metal portion 102, a second metal portion 103, and a third metal portion 104 that are stacked. Side etching is performed on a side surface of the second metal portion 103, so that the first metal portion 102 and the third metal portion 104 protrude from the second metal portion 103 to form a groove. The groove is used as an isolation groove. When a cathode 105 is subsequently formed, a cathode portion 1051 extending around the first metal portion 102 is separated at the groove from a cathode portion 1052 extending on the top of the third metal portion 104, so that water vapor in a hole 106 cannot seep into an image display region 107 along the cathode 105. This isolates the water vapor.

However, although the isolation column 101 of the foregoing structure can separate the cathode 105 and cut off a path for water vapor seeping, based on a conductive characteristic of the isolation column 101, the cathode 105 extending around the first metal portion 102 is electrically connected by using the first metal portion 102, to form a connected path for current transmission (the path for current transmission is shown by a dashed arrow in FIG. 2). When the cathode 105 is energized, a current is transmitted along the path for current transmission all the way to a hole wall of the hole 106. Because a packaging layer 109 is also separated at the hole 106, the hole wall is not protected by the packaging layer 109. Impurities such as an external polarizer, an optically clear adhesive (Optically Clear Adhesive, OCA), and iodine and chlorine introduced by an environment exist in the hole 106. Intrusion of the impurities promotes an electrochemical reaction between metals through which the current flows, for example, an electrochemical reaction between a magnesium-silver alloy configured to form the cathode 105, and titanium and aluminum configured to form the isolation column 101. The metal expands to form a protrusion after the electrochemical reaction. FIG. 2 is a schematic diagram of a structure of a protrusion formed by metal expansion in the conventional technology. As shown in FIG. 2, a protrusion 108 generated by a metal arches the packaging layer 109, causing deformation of the packaging layer 109. As a result, the packaging layer 109 has a crack. The panel fails to be packaged, and the panel has adverse effect such as a dark spot.

To resolve a problem in the conventional technology, an embodiment of this application provides a display panel. A structure of an isolation column in the display panel is designed, so that not only a cathode can be separated by using the isolation column, to cut off a path for water vapor seeping, but also separated cathodes can be electrically insulated from each other, to cut off a path for current transmission. This further avoids a risk of packaging failure caused by an electrochemical reaction between metals.

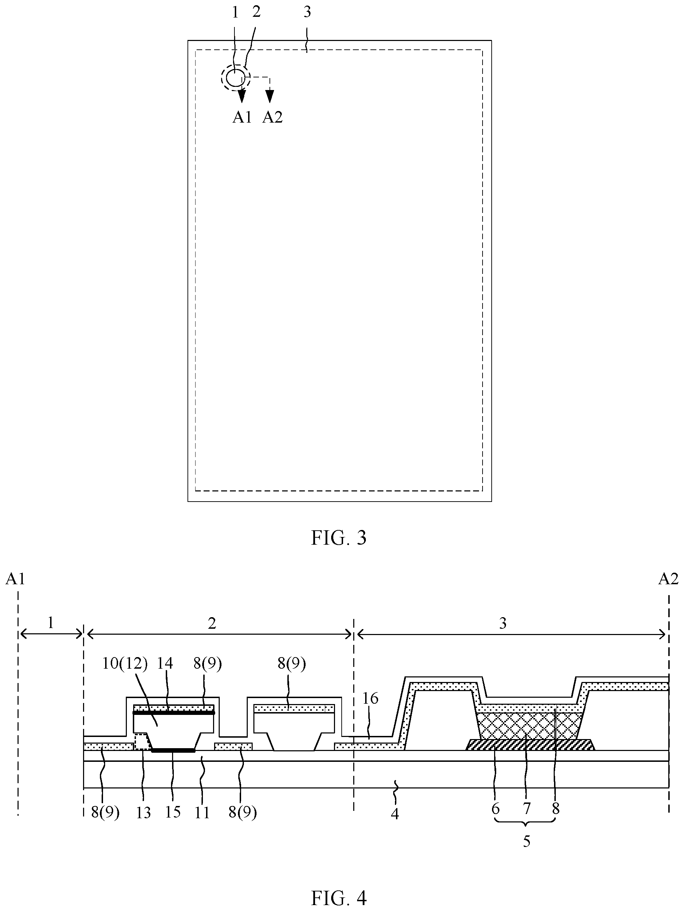

FIG. 3 is a top view of a display panel according to an embodiment of this application. FIG. 4 is a sectional view of FIG. 3 in an A1-A2 direction. As shown in FIG. 3 and FIG. 4, the display panel includes a hole 1, a transition region 2 surrounding the hole 1, and an image display region 3 surrounding the transition region 2. The hole 1 is a hole that is in a display region (Active area, AA) and that is configured to accommodate an optical component such as a camera, and is also referred to as an AA hole. A shape and a position of the hole 1 shown in FIG. 3 are merely examples for description. This is not limited in this embodiment of this application.

The display panel further includes: a substrate 4, where the substrate 4 may be a rigid substrate made of a glass material, or may be a flexible substrate including a flexible film such as polyimide (polyimide, PI) film; a display layer 5, located on a side of the substrate 4, where the hole 1 runs through at least the substrate 4 and the display layer 5, the display layer 5 includes an anode 6, an emissive layer 7, and a cathode 8 that are stacked, and the cathode 8 includes a first cathode portion 9 located in the transition region 2; an isolation column 10, where the isolation column 10 is located on the side of the substrate 4 and located in the transition region 2; and a first film layer 11, in contact with the isolation column 10 and located on a side that is of the isolation column 10 and that faces the substrate 4. That is, the first film layer 11 is a film layer, in the display panel, that is closest to the isolation column 10 and that is in contact with the bottom of the isolation column 10.

The isolation column 10 includes an insulation isolation portion 12. The insulation isolation portion 12 is made of a non-conductive insulation material. At least a part of a side wall of the insulation isolation portion 12 is recessed toward an inside of the insulation isolation portion 12 to form a groove 13, so that the insulation isolation portion 12 forms a structure whose upper part is outwardly convex and whose bottom part is inwardly concave. A surface of a side that is of the insulation isolation portion 12 and that is away from the substrate 4 is a first surface 14. A surface, in contact with the first film layer 11, of a side that is of the insulation isolation portion 12 and that faces the substrate 4 is the second surface 15. The first cathode portion 9 extending on the first film layer 11 is separated at the groove 13 from the first cathode portion 9 extending on the first surface 14.

In this embodiment of this application, the isolation column 10 is provided with the insulation isolation portion 12 that is in contact with the first film layer 11 and that is provided with the groove 13. The groove 13 is used as an isolation groove to separate two parts of the first cathode portion 9 that respectively extend on the first film layer 11 and the first surface 14. In this way, the first cathode portion 9 forms a plurality of discontinuous parts. This effectively cuts off a path for water vapor seeping, and prevents water vapor in the hole 1 from seeping into the image display region 3 along the first cathode portion 9. In addition, based on an insulation characteristic of the insulation isolation portion 12, the two separated parts of the first cathode portion 9 that respectively extend on the first film layer 11 and the first surface 14 are electrically insulated from each other. Besides, because the insulation isolation portion 12 is in contact with the first film layer 11, two separated parts of the first cathode portion 9 that extend on the first surface 14 and that are located on two opposite sides of the insulation isolation portion 12 are also electrically insulated from each other. In this case, the plurality of discontinuous parts formed by the first cathode portion 9 are electrically insulated from each other, so that a path for current transmission is effectively cut off. Even if the cathode 8 in the image display region 3 is energized, a current cannot flow along the first cathode portion 9 toward a hole wall. As a result, no current is transmitted through metals in the transition region 2, and therefore, a corrosive impurity promotes no electrochemical reaction between the metals in the transition region 2. This avoids deformation of a packaging layer 16 caused by metal expansion, and therefore avoids a risk of packaging failure and improves packaging reliability of the display panel.

In addition, refer to FIG. 1 and FIG. 2 again. In the conventional technology, the first metal portion 102 and the third metal portion 104 are configured to protrude from the second metal portion 103 to form the groove of the isolation column 101. Because a metal layer is relatively thin, a protruding part of the third metal portion 104 is likely to break. After the third metal portion 104 breaks, the isolation column 101 does not have the isolation groove any longer. As a result, the cathode portion 1051 and the cathode portion 1052 that originally need to be separated may be continuously disposed. However, in this embodiment of this application, the groove 13 of the isolation column 10 is formed by the insulation isolation portion 12. Compared with the metal layer, an insulation layer has a larger thickness, and therefore has relatively high stability. Therefore, a risk of failure of the groove 13 of the isolation column 10 can be effectively reduced.

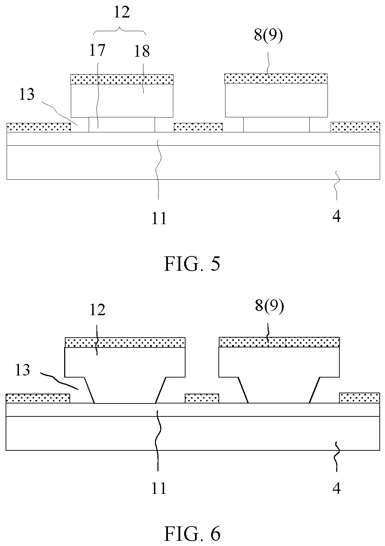

In a feasible implementation, FIG. 5 is a schematic diagram of a structure of an isolation column according to an embodiment of this application. As shown in FIG. 5, the insulation isolation portion 12 includes a first part 17 and a second part 18. The first part 17 and the second part 18 are two film layers independent of each other. The second part 18 is located on a side that is of the first part 17 and that is away from the substrate 4, and the second part 18 covers only a surface of the side that is of the first part 17 and that is away from the substrate 4. The first part 17 is indented to form the groove 13 through a side etching process.

However, in this structure, the first part 17 and the second part 18 are independent of each other, and a contact area between the second part 18 and the first part 17 is relatively small. If the isolation column is subject to a common array process such as high-pressure water cleaning or a high-pressure air knife in a subsequent process, the second part 18 is likely to be detached from the first part 17. Moreover, in a process of the insulation isolation portion 12 of this structure, after the second part 18 is formed, side etching needs to be performed on the first part 17 to form the groove 13. Therefore, an additional device that can perform side etching on the insulation layer further needs to be purchased, resulting in relatively high process costs. In addition, if the first part 17 is an inorganic insulation layer, and the inorganic insulation layer is relatively thin, a height of the groove 13 formed after side etching is relatively small. When the cathode 8 is formed subsequently, to ensure that the cathode 8 can be separated at the groove 13, it needs to be controlled under relatively high process precision and process stability, which leads to relatively high process difficulty.

Therefore, in an implementation of this application, FIG. 6 is a schematic diagram of another structure of an isolation column according to an embodiment of this application. As shown in FIG. 6, the insulation isolation portion 12 is of an integrated structure. To be specific, components of the insulation isolation portion 12 are connected to each other and are integrated. In a process of the display panel, the insulation isolation portion 12 is formed only through a single-step composition process. In this way, a process flow of the insulation isolation portion 12 can be simplified. In addition, when the isolation column 10 is subject to an array process such as high-pressure water cleaning and a high-pressure air knife in a subsequent process, stability of the insulation isolation portion 12 of the integrated structure is higher, and consequently, a phenomenon in which a film layer inside the insulation isolation portion 12 is tilted or broken does not occur. This improves stability of the isolation column 10.

Further, the insulation isolation portion 12 is an organic insulation layer, that is, the insulation isolation portion 12 is made of an organic insulation material.

Affected by a current process capability, compared with an inorganic insulation layer, the organic insulation layer is more likely to form a relatively large film thickness. When the insulation isolation portion 12 is the organic insulation layer, correspondingly, a height that is of the groove 13 in the insulation isolation portion 12 and that is in a direction perpendicular to a plane on which the substrate 4 is located may also be set to a larger value. Subsequently, when the cathode 8 is formed, it may be more likely to ensure that the first cathode portion 9 is separated at the groove 13. It is effectively ensured that the first cathode portion 9 is separated and electrically insulated from each other while process difficulty of the cathode 8 is reduced.

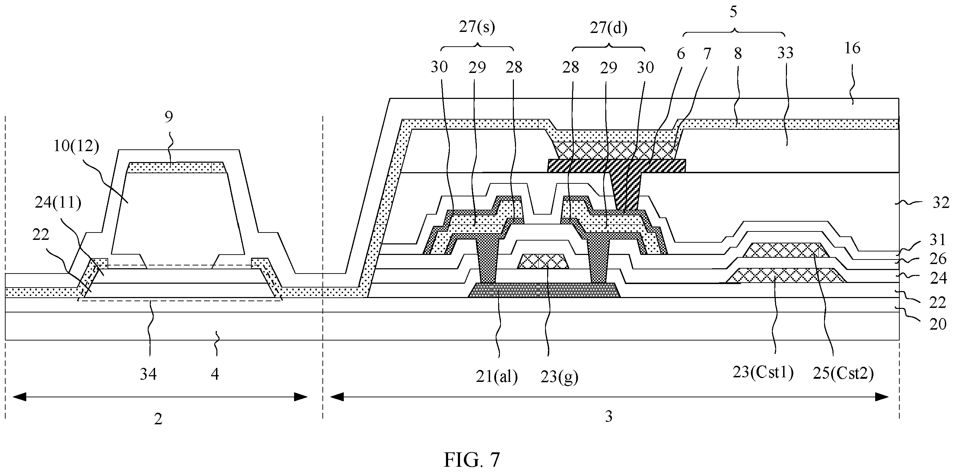

In addition, FIG. 7 is a schematic diagram of a film layer structure of a display panel according to an embodiment of this application. As shown in FIG. 7, the display panel further includes: a buffer (buffer) layer 20, a semiconductor layer 21, a first insulation layer 22, a first metal layer 23, a second insulation layer 24, a second metal layer 25, a third insulation layer 26, a third metal layer 27, a fourth insulation layer 31, and a planarization (planarization, PLN) layer 32. The buffer layer 20 is located on the side of the substrate 4. The buffer layer 20 is configured to perform heat preservation in a subsequent excimer laser annealing process for forming a semiconductor layer 21. The semiconductor layer 21 is located on a side that is of the buffer layer 20 and that is away from the substrate 4. The semiconductor layer 21 is configured to form an active layer al of a transistor component, and may be specifically a polycrystalline silicon layer. The first insulation layer 22 is located on a side that is of the semiconductor layer 21 and that is away from the substrate 4. The first insulation layer 22 is a gate insulation (gate insulating, GI) layer, and is made of an inorganic insulation material such as a SiOₓ material. The first metal layer 23 is located on a side that is of the first insulation layer 22 and that is away from the substrate 4. The first metal layer 23 is configured to form a gate g of the transistor component and a first plate Cst1 of a capacitor component, and is made of a metal molybdenum material. The second insulation layer 24 is located on a side that is of the first metal layer 23 and that is away from the substrate 4. The second insulation layer 24 is also a gate insulating layer, and is made of an inorganic insulation material such as a SiNₓ material. The second metal layer 25 is located on a side that is of the second gate insulation layer and that is away from the substrate 4. The second metal layer 25 is configured to form a second plate Cst2 of the capacitor component, and is made of a metal molybdenum material. The third insulation layer 26 is located on a side that is of the second metal layer 25 and that is away from the substrate 4. The third insulation layer 26 is an interlayer dielectric (interlayer dielectric, ILD) layer, and is made of an inorganic material such as a SiNₓ material. The third metal layer 27 is located on a side that is of the third insulation layer 26 and that is away from the substrate 4. The third metal layer 27 is configured to form a first terminal s and a second terminal d of the transistor component. The third metal layer 27 is a metal composite film layer and includes a first metal sub-layer 28, a second metal sub-layer 29, and a third metal sub-layer 30 that are stacked. In a feasible implementation, the first metal sub-layer 28 and the third metal sub-layer 30 are made of a metal titanium material, and the second metal sub-layer 29 is made of a metal aluminum material. That is, the third metal layer 27 is a titanium/aluminum/titanium three-layer composite structure. The fourth insulation layer 31 is located on a side that is of the third metal layer 27 and that is away from the substrate 4. The fourth insulation layer 31 is also an interlayer dielectric layer, and is made of an inorganic material such as a SiOₓ material. The planarization layer 32 is located on a side that is of the fourth insulation layer 31 and that is away from the substrate 4. The planarization layer 32 is configured to implement film layer planarization, and is made of an organic material.

Further, the anode 6 is located on a side that is of the planarization layer 32 and that is away from the substrate 4. The display layer 5 further includes a pixel define layer 33, and is configured to form an opening for accommodating the emissive layer 7, to limit a light emission region of the display panel. The emissive layer 7 is located in the opening of the pixel define layer 33. The cathode 8 is located on a side that is of the pixel define layer 33 and the emissive layer 7 and that is away from the substrate 4. In addition, the display panel further includes the packaging layer 16. The packaging layer 16 is located on a side that is of the cathode 8 and that is away from the substrate 4, and the packaging layer 16 is configured to package the display panel.

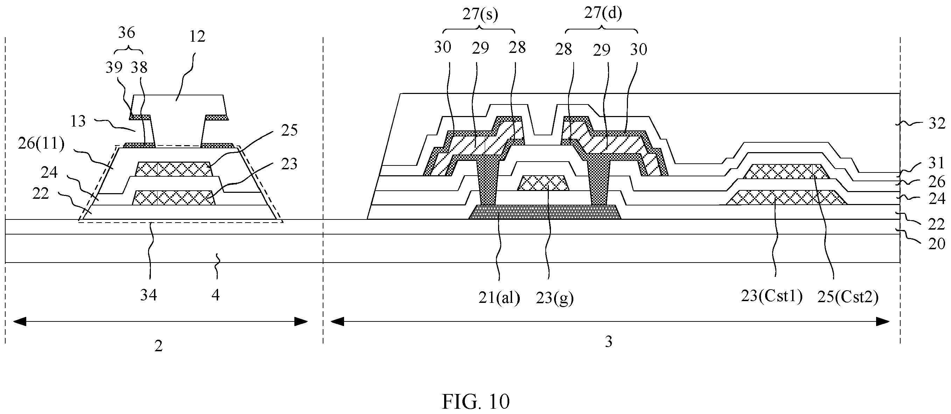

Refer to FIG. 7 again. It should be noted that a base 34 for raising the isolation column 10 may be further disposed between the isolation column 10 and the substrate 4. The base 34 may be specifically formed by etching one or more of the first insulation layer 22, the first metal layer 23, the second insulation layer 24, the second metal layer 25, and the third insulation layer 26. For example, as shown in FIG. 7, the base 34 is formed by etching the first insulation layer 22 and the second insulation layer 24. Alternatively, as shown in FIG. 10, the base 34 is formed by etching the first insulation layer 22, the first metal layer 23, the second insulation layer 24, the second metal layer 25, and the third insulation layer 26.

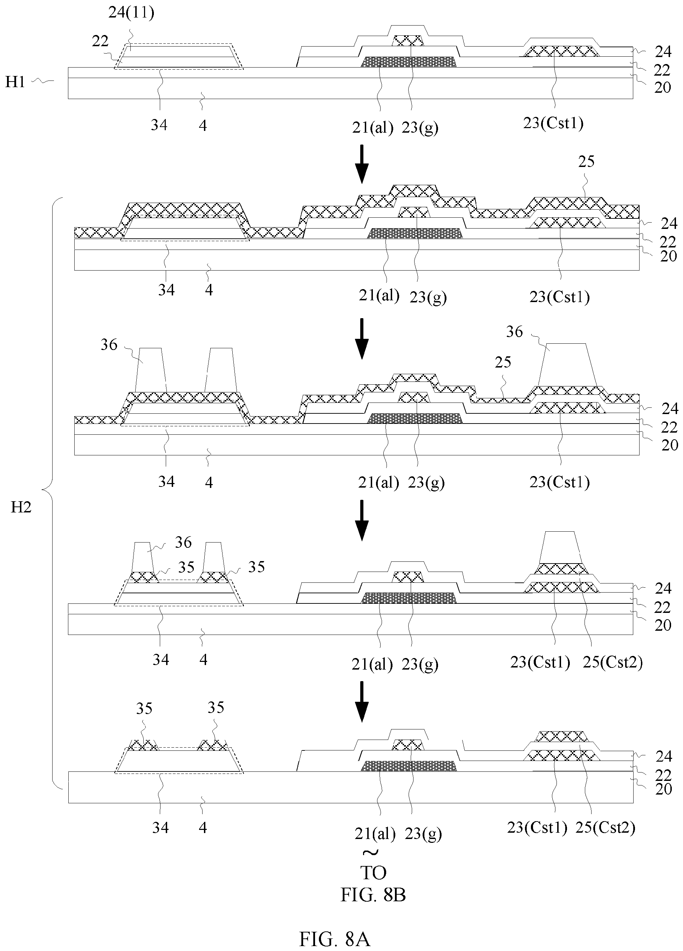

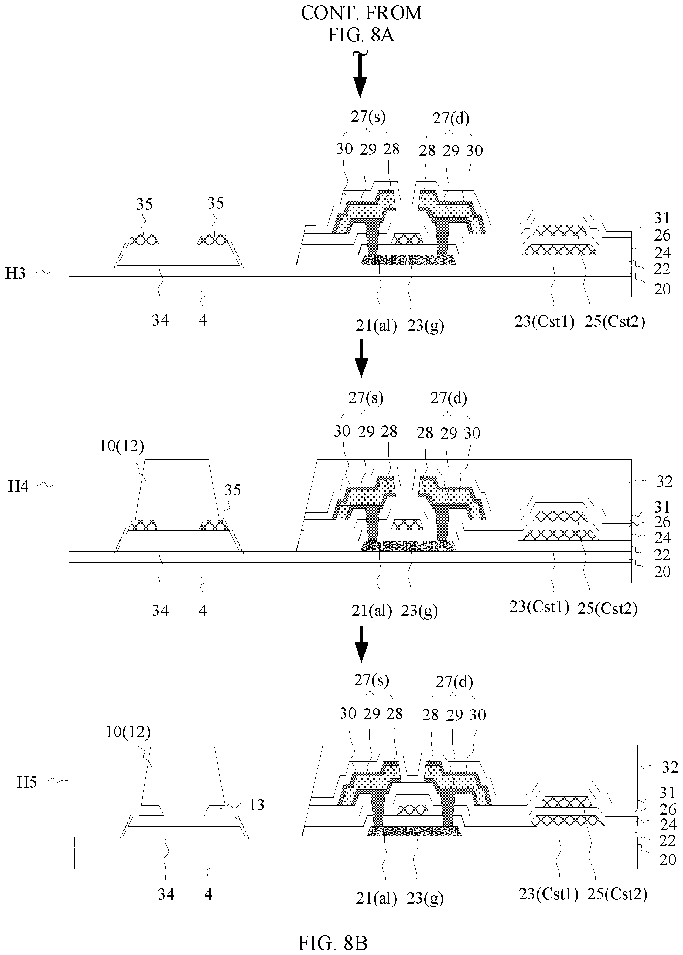

When the insulation isolation portion 12 is an organic insulation layer, the insulation isolation portion 12 may be formed by using the planarization layer 32. With reference to FIG. 8A and FIG. 8B, the following describes a manufacturing method for the isolation column 10 shown in FIG. 7.

Step H1: Form the buffer layer 20, the semiconductor layer 21, the first insulation layer 22, the first metal layer 23, and the second insulation layer 24 in sequence on the substrate 4, where the first insulation layer 22 and the second insulation layer 24 are etched to form the base 34 in the transition region 2.

Step H2: Form the second metal layer 25, and form a sacrificial metal portion 35 located in the transition region 2 by using the second metal layer 25, where a process of forming the sacrificial metal portion 35 by using the second metal layer 25 includes: after the second metal layer 25 is formed, disposing a photoresist 36 at a position at which a metal needs to be retained, etching off a metal in a region outside the photoresist 36 through an exposure process, a development process and an etching process, and removing the photoresist 36, to form the sacrificial metal portion 35 in the transition region 2.

Step H3: Form the third insulation layer 26, the third metal layer 27, and the fourth insulation layer 31 in sequence, where the third insulation layer 26 and the fourth insulation layer 31 on the base 34 are etched off, to expose the sacrificial metal portion 35.

Step H4: Form the planarization layer 32, and etch the planarization layer 32 in the transition region 2, to form the insulation isolation portion 12 on the base 34, where the insulation isolation portion 12 fills a region between sacrificial metal portions 35 and covers a top of the sacrificial metal portion 35.

Step H5: Perform side etching on the sacrificial metal portion 35 by using etching liquid, and remove the entire sacrificial metal portion 35, so that the groove 13 is formed on a side wall that is of the insulation isolation portion 12 and that is in contact with the sacrificial metal portion 35.

Refer to FIG. 7, FIG. 8A and FIG. 8B. It should be noted that, in the foregoing structure, the second insulation layer 24 is located on the side that is of the insulation isolation portion 12 and that faces the substrate 4, and is in contact with the insulation isolation portion 12. Therefore, the first film layer 11 in the foregoing structure is the second insulation layer 24.

Compared with that in the manufacturing process of the insulation isolation portion 12 shown in FIG. 6, in the manufacturing process of the insulation isolation portion 12 in the foregoing structure, the groove 13 of the insulation isolation portion 12 is formed by using the sacrificial metal portion 35. The sacrificial metal portion 35 and an original metal layer in the panel may be formed through a same composition process. Therefore, no additional manufacturing process is required. In addition, there is no need to add a device for performing side etching on the insulation layer. This reduces costs.

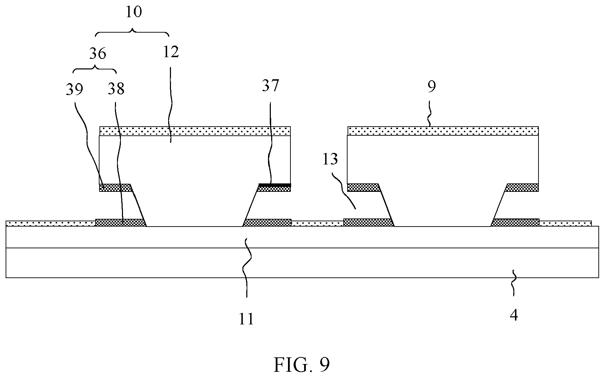

In an implementation, FIG. 9 is a schematic diagram of still another structure of an isolation column according to an embodiment of this application. As shown in FIG. 9, the isolation column 10 further includes a metal isolation portion 36. The metal isolation portion 36 is located in the groove 13. A surface, furthest away from the substrate 4, of a side that is of the metal isolation portion 36 and that is away from the substrate 4 is a third surface 37, and the insulation isolation portion 12 covers the third surface 37.

The metal isolation portion 36 is disposed in the groove 13, and the groove 13 of the insulation isolation portion 12 may be filled by using the metal isolation portion 36. When the isolation column 10 is subject to an array process such as high-pressure water cleaning and a high-pressure air knife in a subsequent process, the insulation isolation portion 12 is prevented from shaking greatly, and stability of the isolation column 10 is improved. In addition, the insulation isolation portion 12 covers the third surface 37 of the metal isolation portion 36. Therefore, the top of the insulation isolation portion 12 isolates the metal isolation portion 36 from the first cathode portion 9 extending on the first surface 14. Even if the first cathode portion 9 extending on the first film layer 11 is electrically connected to the metal isolation portion 36, the first cathode portion 9 extending on the first film layer 11 may still be electrically insulated from the first cathode portion 9 extending on the first surface 14, to effectively ensure that a path for current transmission is cut off.

Refer to FIG. 9 again. In an implementation, in a direction perpendicular to a plane on which the substrate 4 is located, the groove 13 includes a first side and a second side that are opposite to each other. The metal isolation portion 36 includes a first metal portion 38 and a second metal portion 39. The first metal portion 38 is located on the first side of the groove 13. The second metal portion 39 is located on the second side of the groove 13. There is a spacing between the first metal portion 38 and the second metal portion 39.

In the foregoing structure, no other structure is filled between the first metal portion 38 and the second metal portion 39. Therefore, it is easier to ensure that the first cathode portion 9 is discontinuous at the groove 13. In addition, there is the spacing between the first metal portion 38 and the second metal portion 39, and the first metal portion 38 and the second metal portion 39 are electrically insulated from each other. As a result, no conductive path is formed between the first metal portion 38 and the second metal portion 39. This further improves reliability of cutting off a path for current transmission.

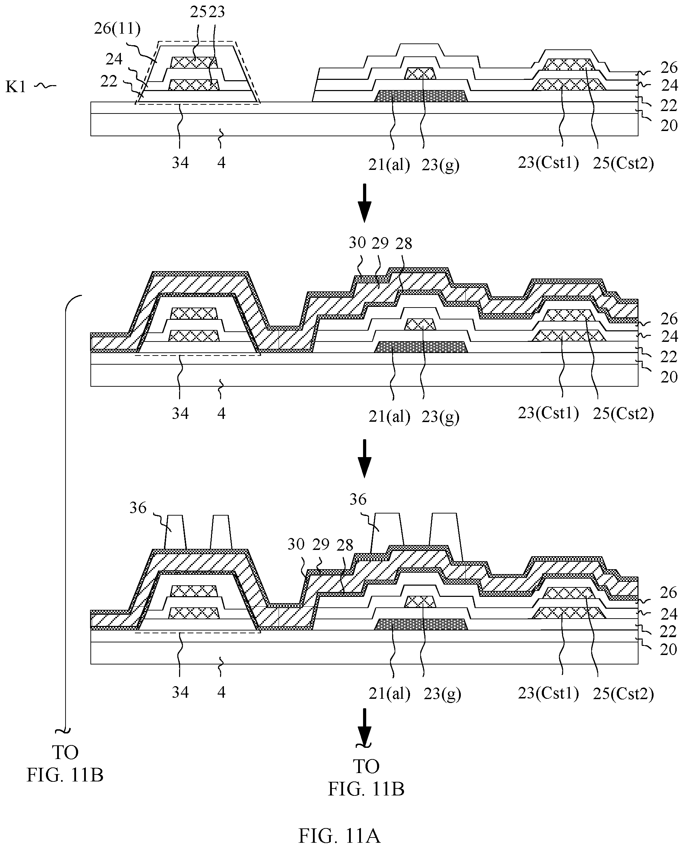

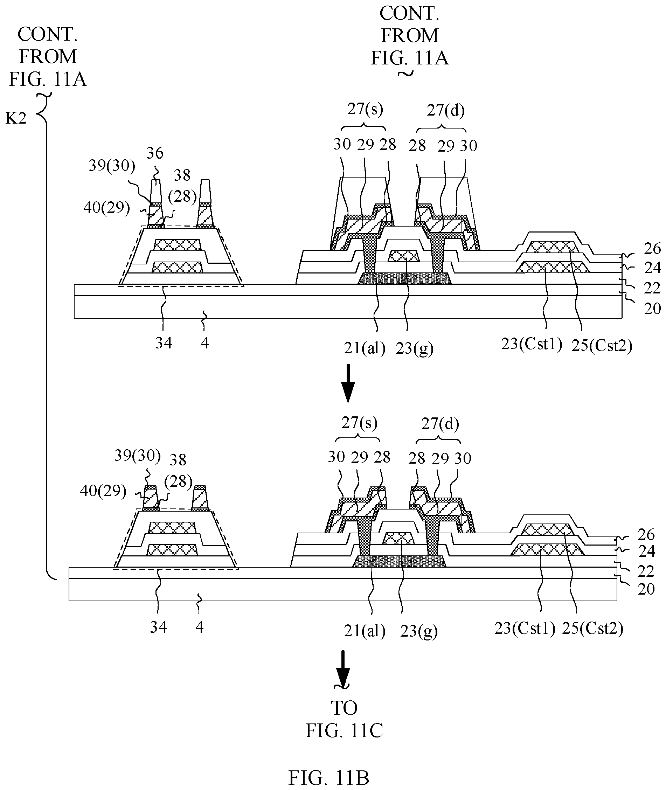

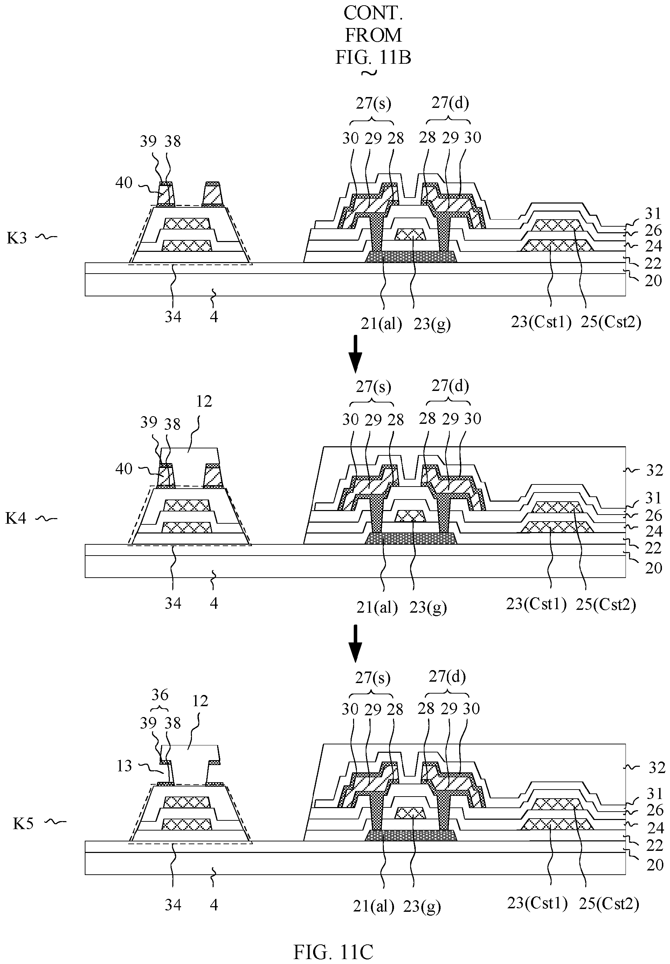

FIG. 10 is a schematic diagram of another film layer structure of a display panel according to an embodiment of this application. When the metal isolation portion 36 includes the first metal portion 38 and the second metal portion 39, as shown in FIG. 10, the first metal portion 38 may be formed by using a first metal sub-layer 28 in the third metal layer 27, and the second metal portion 39 may be formed by using a third metal sub-layer 30 in the third metal layer 27. With reference to FIG. 11A to FIG. 11C, the following describes a manufacturing process of the isolation column 10 shown in FIG. 10.

Step K1: Form a buffer layer 20, a semiconductor layer 21, a first insulation layer 22, a first metal layer 23, a second insulation layer 24, a second metal layer 25, and a third insulation layer 26 in sequence on the substrate 4, where the first insulation layer 22, the first metal layer 23, the second insulation layer 24, the second metal layer 25, and the third insulation layer 26 are etched to form a base 34 in the transition region 2.

Step K2: Form the first metal sub-layer 28, a second metal sub-layer 29, and the third metal sub-layer 30, form the first metal portion 38 in the transition region 2 by using the first metal sub-layer 28, form the second metal portion 39 in the transition region 2 by using the third metal sub-layer 30, and form a third metal portion 40 in the transition region 2 by using the second metal sub-layer 29, where a process of forming the first metal portion 38 by using the first metal sub-layer 28, forming the second metal portion 39 by using the third metal sub-layer 30, and forming the third metal portion 40 by using the second metal sub-layer 29 includes: after the first metal sub-layer 28, the second metal sub-layer 29, and the third metal sub-layer 30 are formed, disposing photoresists 36 at positions at which a metal layer needs to be retained, etching off a metal in a region outside the photoresists 36 through an exposure process, a development process and an etching process, and removing the photoresists 36, to form the first metal portion 38, the second metal portion 39, and the third metal portion 40 in the transition region 2.

Step K3: Form a fourth insulation layer 31, and etch off the fourth insulation layer 31 on the base 34, to expose the first metal portion 38, the second metal portion 39, and the third metal portion 40.

Step K4: Form a planarization layer 32, and etch the planarization layer 32 in the transition region 2, to form the insulation isolation portion 12 on the base 34.

Step K5: Perform side etching on the third metal portion 40, to remove the entire third metal portion 40.

Refer to FIG. 10 and FIG. 11A to FIG. 11C. It should be noted that, in the foregoing structure, the third insulation layer 26 is located on the side that is of the insulation isolation portion 12 and that faces the substrate 4, and is in contact with the insulation isolation portion 12. Therefore, the first film layer 11 in the foregoing structure is the third insulation layer 26.

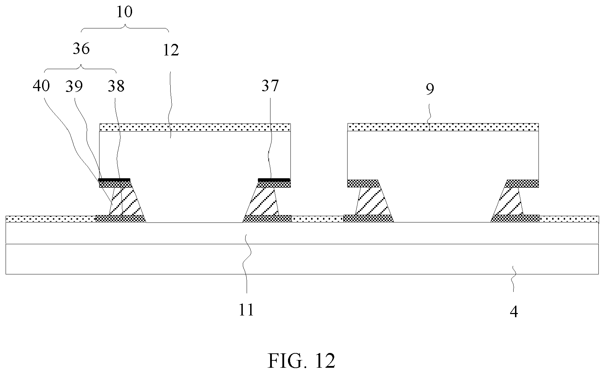

In an implementation, FIG. 12 is a schematic diagram of yet another structure of an isolation column according to an embodiment of this application. As shown in FIG. 12, the metal isolation portion 36 further includes the third metal portion 40, the third metal portion 40 is located between the first metal portion 38 and the second metal portion 39, and the first metal portion 38 and the second metal portion 39 separately protrude from the third metal portion 40 in a direction away from an inside of the insulation isolation portion 12.

When the metal isolation portion 36 includes the third metal portion 40 located between the first metal portion 38 and the second metal portion 39, the metal isolation portion 36 can more stably support the insulation isolation portion 12. This avoids shaking of the insulation isolation portion 12 under an external force. In addition, the first metal portion 38 and the second metal portion 39 protrude from the third metal portion 40, which is equivalent to that a side wall of the third metal portion 40 contracts inward to form a gap. The gap can also block the first cathode portion 9, so that the first cathode portion 9 is discontinuously disposed at the gap. In addition, it should be noted that, although the first metal portion 38 and the second metal portion 39 may be electrically connected by using the third metal portion 40, the insulation isolation portion 12 covers the third metal portion 40. Therefore, the insulation isolation portion 12 can still electrically insulate the metal isolation portion 36 from the first cathode portion 9 extending on the first surface 14, so that the first cathode portion 9 extending on the first film layer 11 and the first cathode portion 9 extending on the first surface 14 are electrically insulated. This ensures that the separated parts of the first cathode portion are electrically insulated from each other.

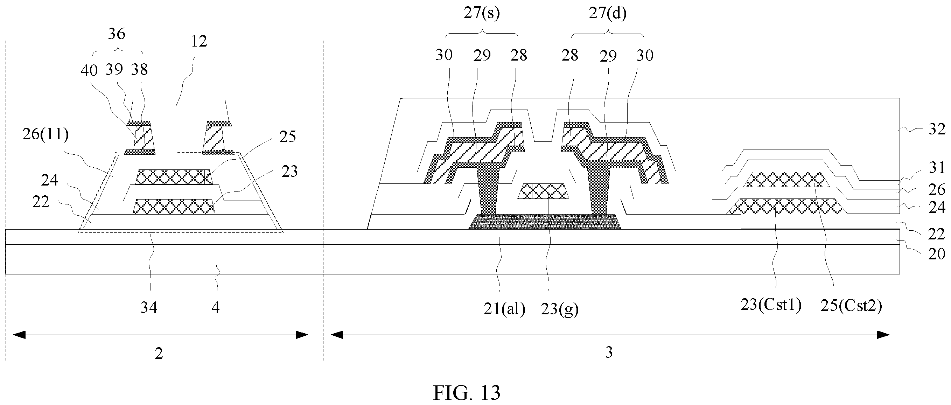

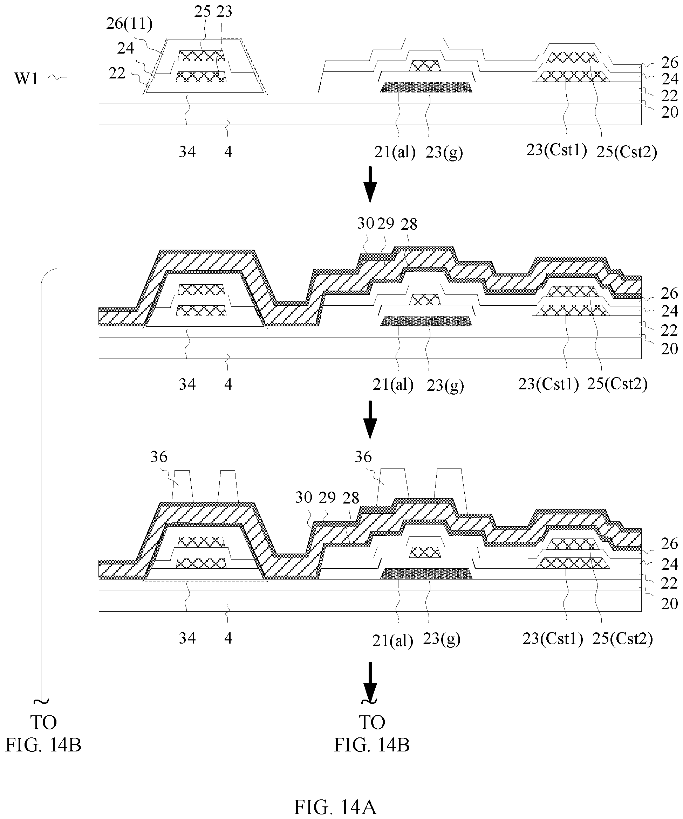

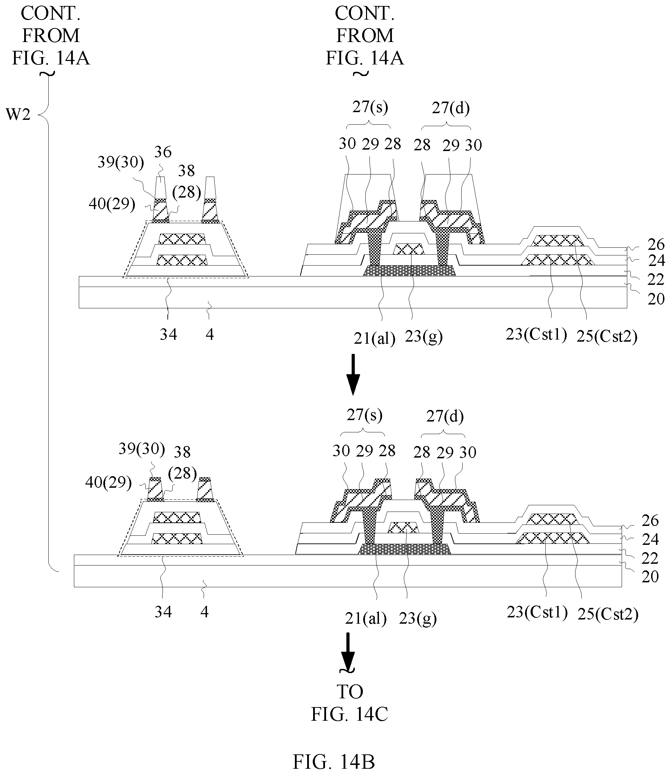

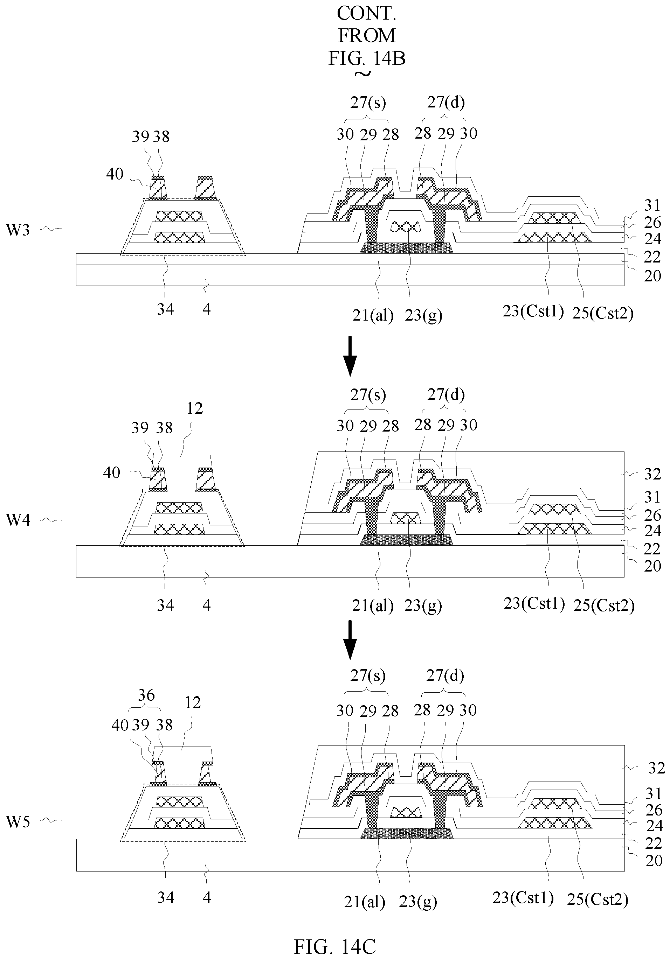

FIG. 13 is a schematic diagram of still another film layer structure of a display panel according to an embodiment of this application. When the metal isolation portion 36 further includes the third metal portion 40, as shown in FIG. 13, the third metal portion 40 may be formed by using the second metal sub-layer 29. With reference to FIG. 14A to FIG. 14C, the following describes a manufacturing process of the isolation column 10 shown in FIG. 13.

A procedure of step W1 to step W4 is the same as a procedure of step K1 to step K4 shown in FIG. 11A to FIG. 11C, and details are not described herein again.

Step W5: Perform side etching on the third metal portion 40, to remove a part of the third metal portion 40, so that the first metal portion 38 and the second metal portion 39 separately protrude from the third metal portion 40 in a direction away from the inside of the insulation isolation portion 12.

It should be noted that, in this embodiment of this application, the first metal portion 38 is formed by using the first metal sub-layer 28, the second metal portion 39 is formed by using the third metal sub-layer 30, and the third metal portion 40 is formed by using the second metal sub-layer 29. That is, the metal isolation portion 36 is also a titanium/aluminum/titanium three-layer composite structure. In this case, the original process flow of the panel does not need to be greatly adjusted, and only a pattern design of a mask needs to be adjusted. A pattern formed after the first metal sub-layer 28, the second metal sub-layer 29, and the third metal sub-layer 30 are etched is changed, and then secondary side etching is performed on the second metal sub-layer 29 configured to form the third metal portion 40. The process flow is simple, and the metal isolation portion 36 does not need to occupy additional film layer space.

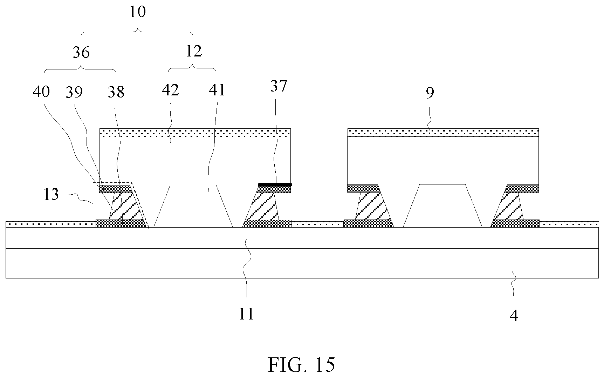

In an implementation, FIG. 15 is a schematic diagram of still yet another structure of an isolation column according to an embodiment of this application. As shown in FIG. 15, the insulation isolation portion 12 includes two grooves 13 that are opposite to each other. The isolation column 10 includes two metal isolation portions 36. The two metal isolation portions 36 are respectively located in the two grooves 13. On this basis, the insulation isolation portion 12 includes a first insulation portion 41 and a second insulation portion 42. The first insulation portion 41 is located between the two metal isolation portions 36. The second insulation portion 42 covers a side wall of the first insulation portion 41 and a surface of a side that is of the first insulation portion 41 and that is away from the substrate 4. The second insulation portion 42 further covers the third surface 37 of the two metal isolation portions 36.

In this way, the insulation isolation portion 12 includes two film layers: the first insulation portion 41 and the second insulation portion 42. A total thickness of the two insulation portions forms a thickness of the insulation isolation portion 12. The thickness of the two insulation portions is superposed, so that the total thickness of the insulation isolation portion 12 is increased more easily. In this way, the insulation isolation portion 12 has better film layer flatness and higher stability. Moreover, in addition to a surface of a side that is of the first insulation portion 41 and that is away from the substrate 4, the second insulation portion 42 further covers the side wall of the first insulation portion 41. A contact area between the two insulation portions is larger, and the two insulation portions are not easily detached under an external force.

Further, the first insulation portion 41 is an organic insulation layer or an inorganic insulation layer, and the second insulation portion 42 is an organic insulation layer or an inorganic insulation layer.

The following describes the first insulation portion 41 and the second insulation portion 42 by using three structures as examples.

### Structure 1:

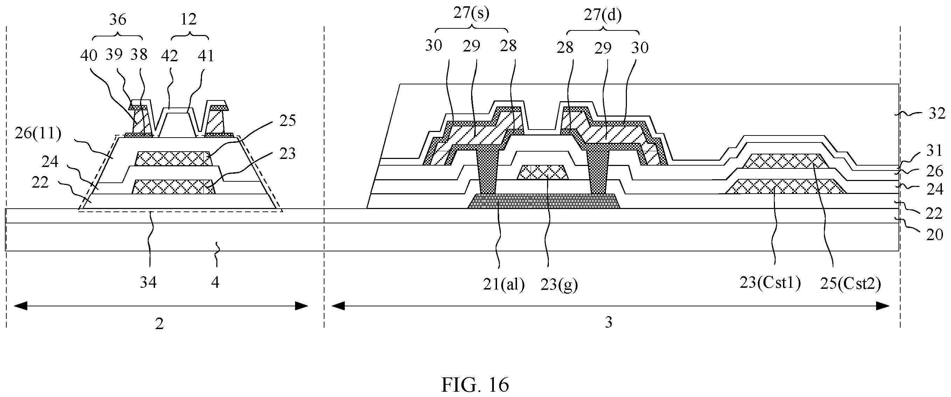

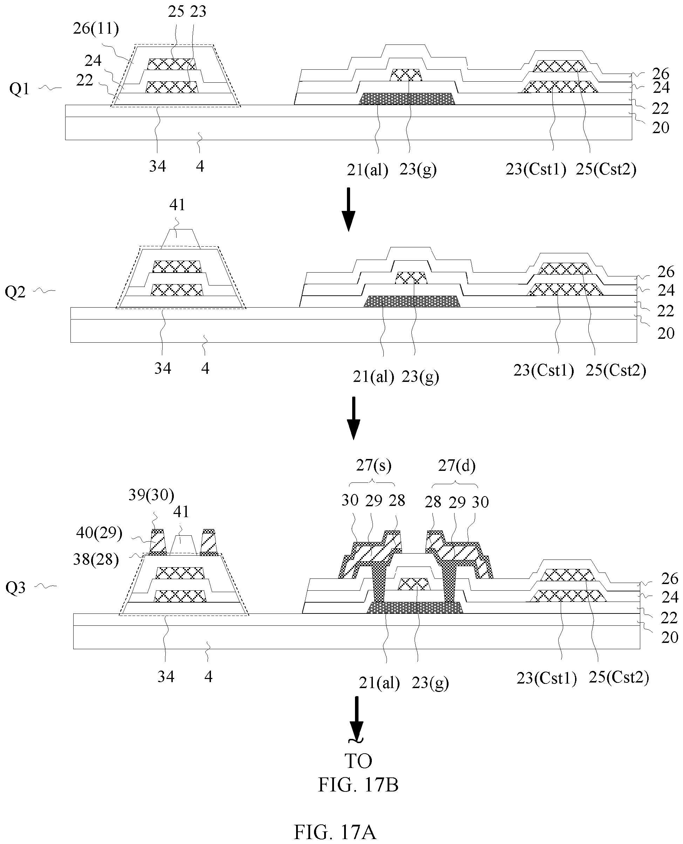

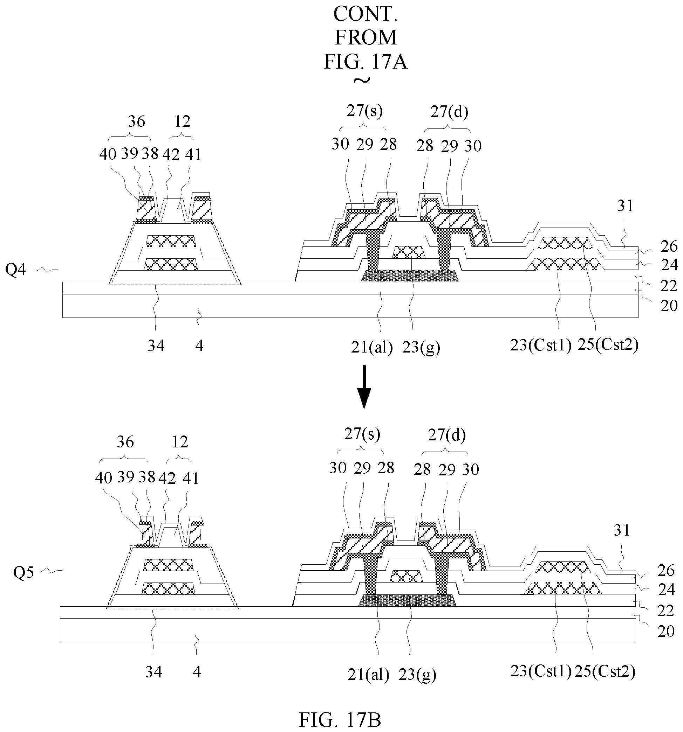

The first insulation portion 41 is an organic insulation layer, and the second insulation portion 42 is an inorganic insulation layer. FIG. 16 is a schematic diagram of yet another film layer structure of a display panel according to an embodiment of this application. FIG. 17A and FIG. 17B are a flowchart of a process of a manufacturing method for an isolation column corresponding to FIG. 16. With reference to FIG. 16, FIG. 17A and FIG. 17B, the following describes a manufacturing process of the isolation column 10.

Step Q1: Form a buffer layer 20, a semiconductor layer 21, a first insulation layer 22, a first metal layer 23, a second insulation layer 24, a second metal layer 25, and a third insulation layer 26 in sequence on the substrate 4, where the first insulation layer 22, the first metal layer 23, the second insulation layer 24, the second metal layer 25, and the third insulation layer 26 are etched to form a base 34 in the transition region 2.

Step Q2: Form the first insulation portion 41 on the base 34.

Step Q3: Form a first metal sub-layer 28, a second metal sub-layer 29, and a third metal sub-layer 30, form a first metal portion 38 in the transition region 2 by using the first metal sub-layer 28, form a third metal portion 40 in the transition region 2 by using the second metal sub-layer 29, and form a second metal portion 39 in the transition region 2 by using the third metal sub-layer 30. A specific forming process is described in FIG. 11A to FIG. 11C and FIG. 14A to FIG. 14C, and details are not described herein again.

Step Q4: Form a fourth insulation layer 31, and form the second insulation portion 42 in the transition region 2 by using the fourth insulation layer 31.

Step Q5: Perform side etching on the third metal portion 40, to entirely or partially remove the third metal portion 40.

It should be noted that the display panel may include two third metal layers 27. The two third metal layers 27 are both located between the third insulation layer 26 and the fourth insulation layer 31. One of the third metal layers 27 forms a first terminal s and a second terminal d of the transistor component, and forms a data line for providing a data signal to the transistor component and a first power signal line for providing a power signal to the transistor component. The other of the third metal layers 27 is configured to form a second power signal line for providing a power signal to the transistor component. The first power signal line and the second power signal line are cross-connected to form a mesh structure and are electrically connected, to reduce an overall load of a power signal line and reduce attenuation of the power signal in a transmission process. There is a fifth insulation layer between the two third metal layers 27. In this case, the first insulation portion 41 formed in step Q2 may be formed by using the fifth insulation layer.

In the foregoing structure, both the first insulation portion 41 and the second insulation portion 42 may be formed through a same composition process as an original film layer in the display panel. This not only simplifies a process flow, but also does not occupy an additional thickness of the film layer, thereby facilitating implementation of a light and thin design of the display panel.

### Structure 2:

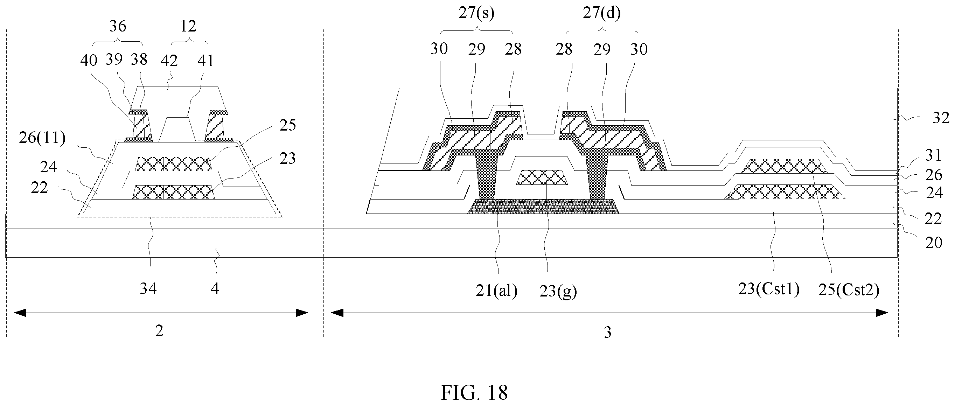

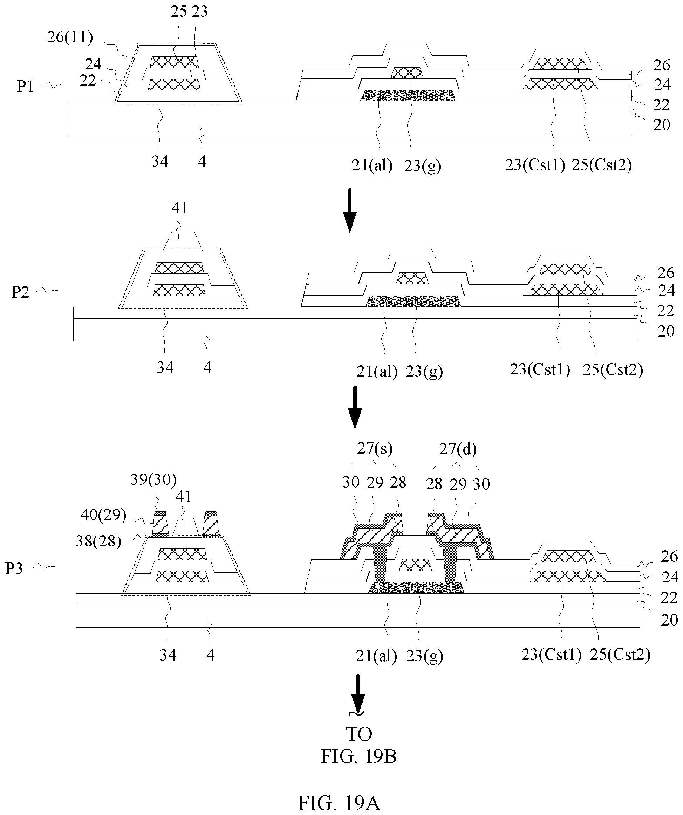

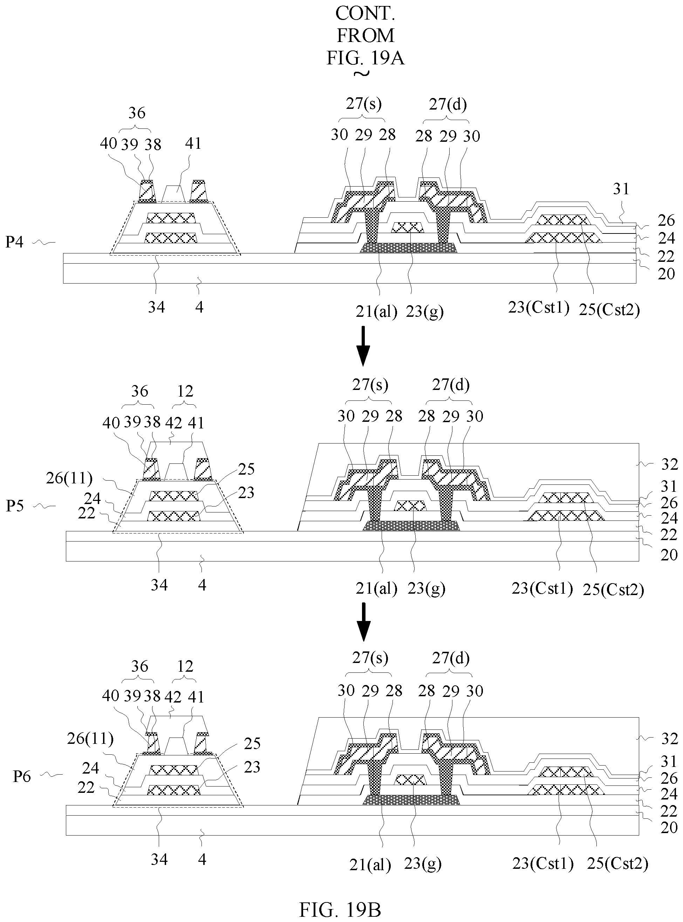

The first insulation portion 41 is an organic insulation layer, and the second insulation portion 42 is an organic insulation layer. FIG. 18 is a schematic diagram of still yet another film layer structure of a display panel according to an embodiment of this application. FIG. 19A and FIG. 19B are a flowchart of a process of a manufacturing method for an isolation column corresponding to FIG. 18. With reference to FIG. 18, FIG. 19A and FIG. 19B, the following describes a manufacturing process of the isolation column 10.

Step P1: Form a buffer layer 20, a semiconductor layer 21, a first insulation layer 22, a first metal layer 23, a second insulation layer 24, a second metal layer 25, and a third insulation layer 26 in sequence on the substrate 4, where the first insulation layer 22, the first metal layer 23, the second insulation layer 24, the second metal layer 25, and the third insulation layer 26 are etched to form a base 34 in the transition region 2.

Step P2: Form the first insulation portion 41 on the base 34. Same as the foregoing embodiments, the first insulation portion 41 may be formed by using a fifth insulation layer, and details are not described herein again.

Step P3: Form a first metal sub-layer 28, a second metal sub-layer 29, and a third metal sub-layer 30, form a first metal portion 38 in the transition region 2 by using the first metal sub-layer 28, form a third metal portion 40 in the transition region 2 by using the second metal sub-layer 29, and form a second metal portion 39 in the transition region 2 by using the third metal sub-layer 30. A specific forming process is described in FIG. 11A to FIG. 11C and FIG. 14A to FIG. 14C, and details are not described herein again.

Step P4: Form a fourth insulation layer 31, and etch off the fourth insulation layer 31 on the base 34, to expose the first metal portion 38, the second metal portion 39, the third metal portion 40, and the first insulation portion 41.

Step P5: Form a planarization layer 32, form a planarization layer 32, and etch the planarization layer 32 in the transition region 2, to form the second insulation portion 42.

Step P6: Perform side etching on the third metal portion 40, to entirely or partially remove the third metal portion 40.

In the foregoing structure, both the first insulation portion 41 and the second insulation portion 42 may be formed through a same composition process as an original film layer in the display panel. This not only simplifies a process flow, but also does not occupy an additional thickness of the film layer, thereby facilitating implementation of a light and thin design of the display panel. Moreover, the organic insulation layer is more likely to have a larger thickness. Therefore, when both the first insulation portion 41 and the second insulation portion 42 are organic insulation layers, a total thickness of the insulation isolation portion 12 is larger, and flatness is better. In addition, the second insulation portion 42 can be configured to make a relatively large spacing between the first cathode portion 9 extending on the first surface 14 and the metal isolation portion 36. This further avoids an electrical connection between the first cathode part 9 and the metal isolation portion 36. In addition, when the second insulation portion 42 is relatively thick, the second insulation portion 42 has a better reinforcement function, and protects the second metal layer 25 to a greater extent, to prevent the second metal layer 25 from being washed off in a subsequent process.

### Structure 3:

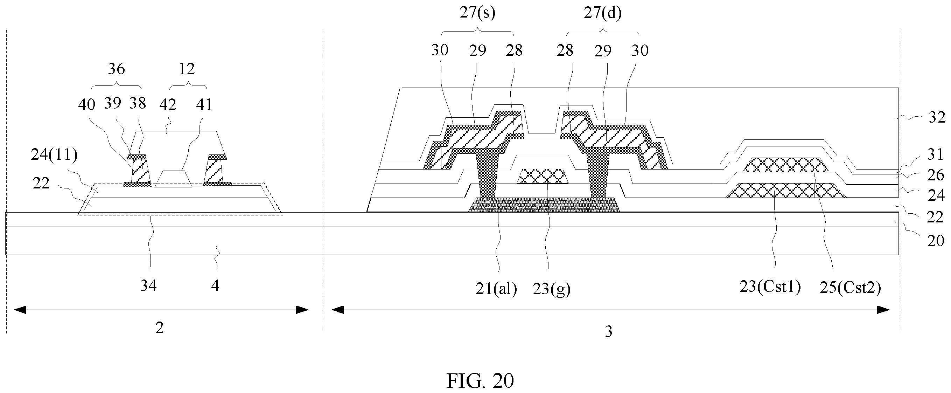

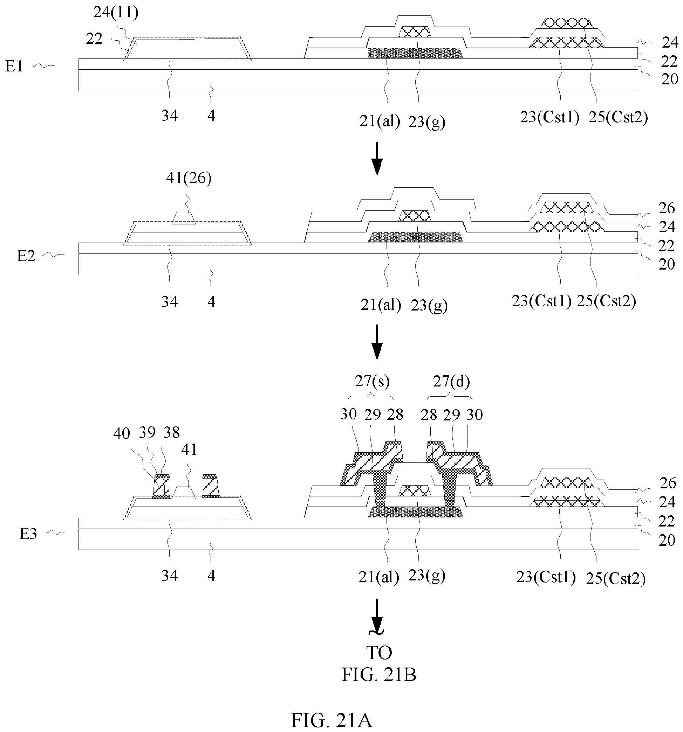

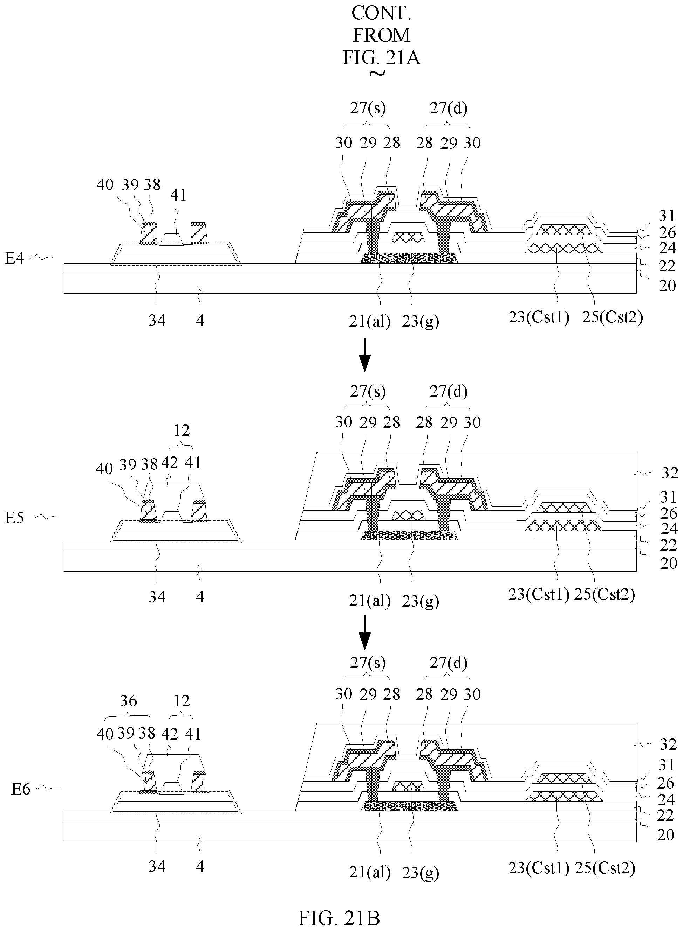

The first insulation portion 41 is an inorganic insulation layer, and the second insulation portion 42 is an organic insulation layer. FIG. 20 is a schematic diagram of a further film layer structure of a display panel according to an embodiment of this application. FIG. 21A and FIG. 21B are a flowchart of a process of a manufacturing method for an isolation column corresponding to FIG. 20. With reference to FIG. 20, FIG. 21A and FIG. 21B, the following describes a manufacturing process of the isolation column 10.

Step E1: Form a buffer layer 20, a semiconductor layer 21, a first insulation layer 22, a first metal layer 23, a second insulation layer 24, and a second metal layer 25 in sequence on the substrate 4, where the first insulation layer 22 and the second insulation layer 24 are etched to form a base 34 in the transition region 2.

Step E2: Form a third insulation layer 26, etch the third insulation layer 26 in the transition region 2, and form the first insulation portion 41 by using the third insulation layer 26.

Step E3: Form a first metal sub-layer 28, a second metal sub-layer 29, and a third metal sub-layer 30, form a first metal portion 38 in the transition region 2 by using the first metal sub-layer 28, form a third metal portion 40 in the transition region 2 by using the second metal sub-layer 29, and form a second metal portion 39 in the transition region 2 by using the third metal sub-layer 30. A specific forming process is described in FIG. 11A to FIG. 11C and FIG. 14A to FIG. 14C, and details are not described herein again.

Step E4: Form a fourth insulation layer 31, and etch off the fourth insulation layer 31 on the base 34, to expose the first metal portion 38, the second metal portion 39, the third metal portion 40, and the first insulation portion 41.

Step E5: Form a planarization layer 32, etch the planarization layer 32 in the transition region 2, and form the second insulation portion 42 by using the planarization layer 32.

Step E6: Perform side etching on the third metal portion 40, to entirely or partially remove the third metal portion 40.

In the foregoing structure, both the first insulation portion 41 and the second insulation portion 42 may be formed through a same composition process as an original film layer in the display panel. This not only simplifies a process flow, but also does not occupy an additional thickness of the film layer, thereby facilitating implementation of a light and thin design of the display panel.

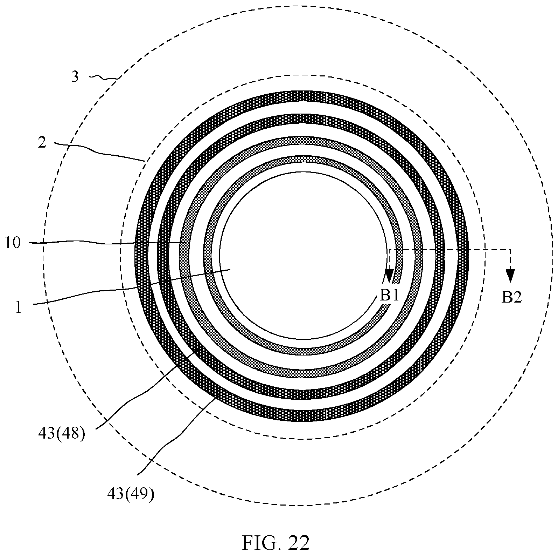

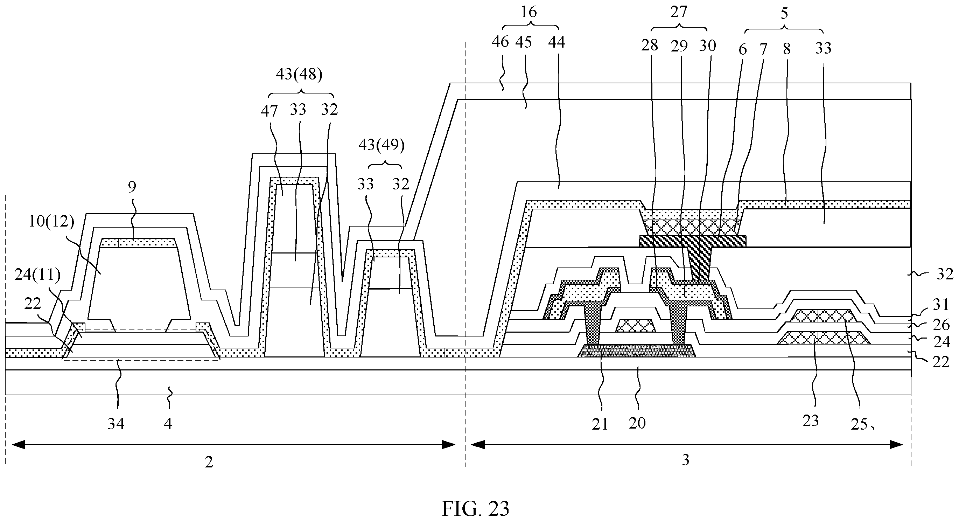

In an implementation, FIG. 22 is a top view of an isolation column according to an embodiment of this application. FIG. 23 is a sectional view of FIG. 22 in a B1-B2 direction. As shown in FIG. 22 and FIG. 23, the display panel further includes a dam (Dam) 43 located in the transition region 2, and at least a part of isolation columns 10 are located on a side that is of the dam 43 and that is close to the hole 1.

It should be noted that the packaging layer 16 of the display panel includes a first inorganic packaging layer 44, an organic packaging layer 45, and a second inorganic packaging layer 46. The first inorganic packaging layer 44 and the second inorganic packaging layer 46 extend from the image display region 3 to an edge position of the hole 1. The organic packaging layer 45 is truncated by the dam 43, and extends from the image display region 3 to a position of the dam 43 that is closest to the image display region 3. The dam 43 may be formed by superposing at least two of a planarization layer 32, a pixel define layer 33, and an organic support layer 47. The dam 43 may specifically include a first dam 48 and a second dam 49. The first dam 48 is located on a side that is of the second dam 49 and that is close to the hole 1. A height of the first dam 48 in a direction perpendicular to a plane on which the substrate 4 is located is greater than a height of the second dam 49 in a direction perpendicular to a plane in which the substrate 4 is located, to further truncate the organic packaging layer 45 by using the first dam 48. For example, refer to FIG. 23 again. The first dam 48 is formed by superposing the planarization layer 32, the pixel define layer 33, and the organic support layer 47, and the second dam 49 is formed by superposing the planarization layer 32 and the pixel define layer 33.

When the at least a part of isolation columns 10 are located on the side that is of the dam 43 and that is close to the hole 1, the part of isolation columns 10 are relatively close to the hole 1, and the part of isolation columns 10 may enable the first cathode portion 9 closer to the hole 1 to be separated and electrically insulated from each other. This prevents, to a greater extent, water vapor in the hole 1 from seeping inward along the first cathode portion 9, and improves water vapor isolation performance.

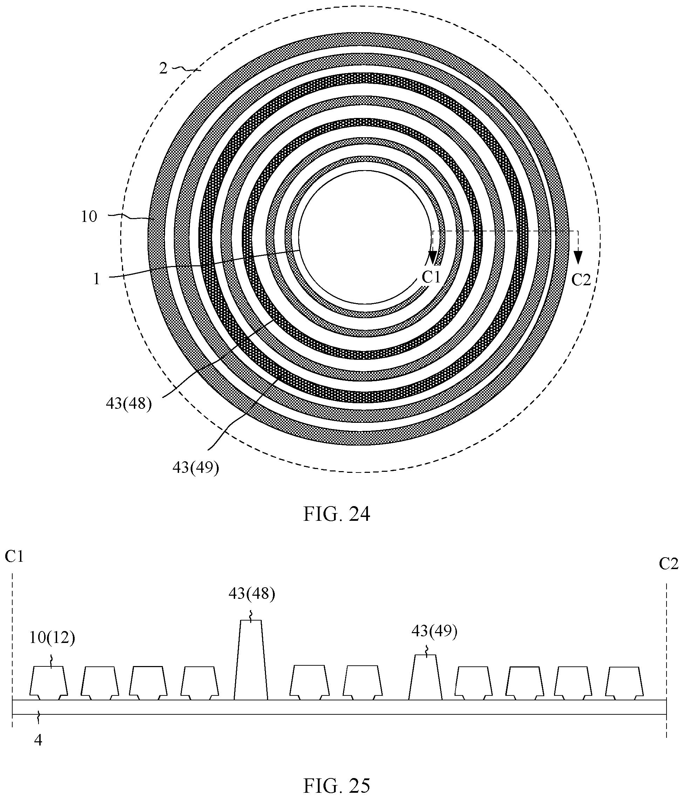

In addition, FIG. 24 is another top view of an isolation column according to an embodiment of this application. FIG. 25 is a sectional view of FIG. 24 in a C1-C2 direction. As shown in FIG. 24 and FIG. 25, to further cut off a path for water vapor transmission and a path for current transmission, the part of isolation columns 10 are located on a side that is of the dam 43 and that is far away from the hole 1, and/or the part of isolation columns 10 are located between the first dam 48 and the second dam 49.

Refer to FIG. 22 and FIG. 24 again. It should be noted that, in this embodiment of this application, to cut off a path for water vapor seeping and the path for current transmission in an all-round manner, the isolation column 10 may be disposed around an edge of the hole 1.

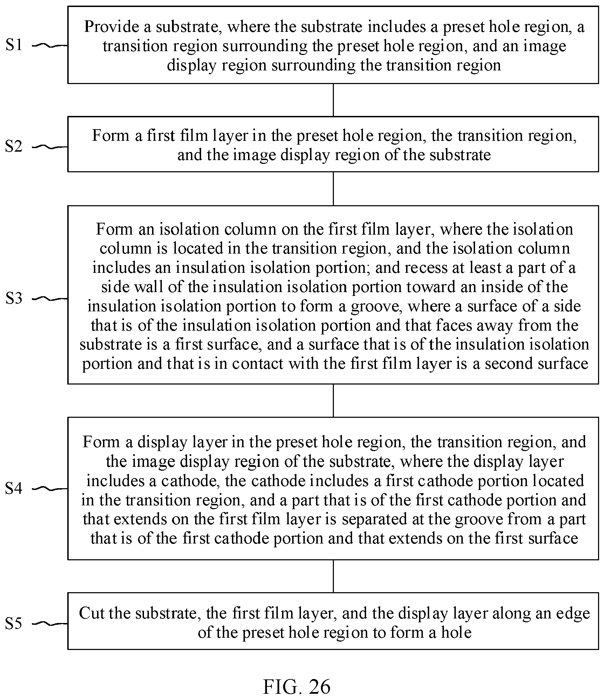

An embodiment of this application further provides a manufacturing method for a display panel. The manufacturing method is used to manufacture the foregoing display panel. With reference to FIG. 1, FIG. 26 is a flowchart of a manufacturing method according to an embodiment of this application. As shown in FIG. 26, the manufacturing method includes the following steps.

Step S1: Provide a substrate 4, where the substrate 4 includes a preset hole region, a transition region 2 surrounding the preset hole region, and an image display region 3 surrounding the transition region 2.

Step S2: Form a first film layer 11 in the preset hole region, the transition region 2, and the image display region 3 of the substrate 4.

Step S3: Form an isolation column 10 on the first film layer 11, where the isolation column 10 is located in the transition region 2, and the isolation column 10 includes an insulation isolation portion 12; and recess at least a part of a side wall of the insulation isolation portion 12 toward an inside of the insulation isolation portion 12 to form a groove 13, where a surface of a side that is of the insulation isolation portion 12 and that is away from the substrate 4 is a first surface 14, and a surface that is of the insulation isolation portion 12 and that is in contact with the first film layer 11 is a second surface 15.

Step S4: Form a display layer 5 in the preset hole region, the transition region 2, and the image display region 3 of the substrate 4, where the display layer 5 includes a cathode 8, the cathode 8 includes a first cathode portion 9 located in the transition region 2, and the first cathode portion 9 extending on the first film layer 11 is separated at the groove 13 from the first cathode portion 9 extending on the first surface 14.

Step S5: Cut the substrate 4, the first film layer 11, and the display layer 5 along an edge of the preset hole region to form a hole 1.

The display panel is formed by using the foregoing method. The isolation column 10 is provided with the insulation isolation portion 12 that is in contact with the first film layer 11 and that is provided with the groove 13, so that two parts of the first cathode portion 9 that respectively extend on the first film layer 11 and the first surface 14 may be separated by using the groove 13, and a path for water vapor seeping can be effectively cut off. In addition, based on a design of the insulation isolation portion 12, the two parts of the first cathode portion 9 that extend on the first surface 14 and that are located on two opposite sides of the insulation isolation portion 12 may also be electrically insulated from each other. Further, a plurality of discontinuous parts formed by the first cathode portion 9 are electrically insulated from each other, and a path for current transmission in the first cathode portion 9 is effectively cut off. In this way, an electrochemical reaction condition is eliminated, and metals in the transition region 2 do not undergo an electrochemical reaction under promotion of a corrosive impurity. This avoids a risk of packaging failure caused by a crack due to deformation of a packaging layer.

In an implementation, the transition region 2 includes a preset groove region, and the preset groove region is a region in which the groove 13 is formed.

With reference to FIG. 7, FIG. 8A and FIG. 8B, after forming the first film layer 11, the manufacturing method further includes: forming a sacrificial metal portion 35 on the first film layer 11, where the sacrificial metal portion 35 is located in the preset groove region.

A process of forming the insulation isolation portion 12 on the first film layer 11, and recessing at least the part of the side wall of the insulation isolation portion 12 toward the inside of the insulation isolation portion 12 to form the groove 13 includes: forming the insulation isolation portion 12 on the first film layer 11, where the insulation isolation portion 12 covers the sacrificial metal portion 35; and removing the sacrificial metal portion 35, so that a side wall that is of the insulation isolation portion 12 and that is in contact with the sacrificial metal portion 35 form the groove 13.

The specific process is described in detail in the embodiment corresponding to FIG. 8A and FIG. 8B, and details are not described herein again.

With reference to the descriptions of FIG. 8A and FIG. 8B in the foregoing embodiments, the insulation isolation portion 12 is prepared through the process. The groove 13 of the insulation isolation portion 12 is formed by using the sacrificial metal portion 35. The sacrificial metal portion 35 and an original metal layer in the panel may be formed through a same composition process. Therefore, no additional process is required. In addition, in the manufacturing method, there is no need to add a device for performing side etching on the insulation layer. This reduces costs.

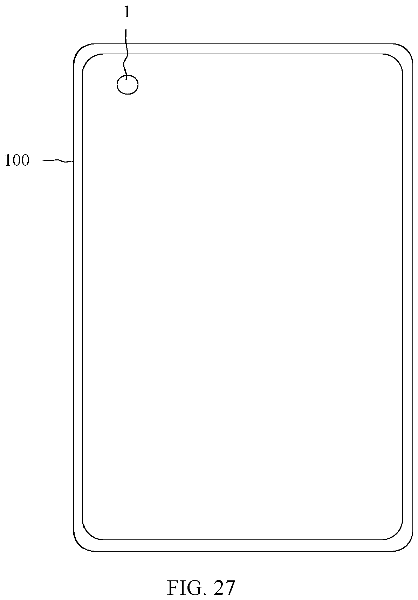

An embodiment of this application further provides an electronic device. FIG. 27 is a schematic diagram of a structure of an electronic device according to an embodiment of this application. As shown in FIG. 27, the electronic device includes a display panel 100. A specific structure of the display panel 100 is described in detail in the foregoing embodiments, and details are not described herein again. Certainly, the electronic device shown in FIG. 27 is merely an example for description. The electronic device may be any electronic device having a display function, such as a smartwatch, a mobile phone, a tablet computer, or a game console.

In addition, it should be further noted that, in addition to the display panel 100, the electronic device may further include structures such as cover glass (Cover Glass, CG), optically clear adhesive (Optically Clear Adhesive, OCA), a polarizer (Polarizer, POL), a back support film (Ufilm), and a heat dissipation film. These structures are the same as those in the conventional technology, and details are not described herein again.

The foregoing descriptions are merely preferred embodiments of this application, but not intended to limit this application. Any modification, equivalent replacement, improvement, or the like made without departing from the spirit and principle of this application shall fall within the protection scope of this application.

Finally, it should be noted that the foregoing embodiments are merely intended for describing the technical solutions of this application other than limiting this application. Although this application is described in detail with reference to the foregoing embodiments, a person skilled in the art should understand that they may still make modifications to the technical solutions described in the foregoing embodiments or make equivalent replacements to some or all technical features thereof, without departing from the scope of the technical solutions in embodiments of this application.

## Claims

1. A display panel, comprising:
a hole, a transition region surrounding the hole, and an image display region surrounding the transition region;
a substrate;
a display layer, located on a side of the substrate, wherein the hole runs through at least the display layer, the display layer comprises a cathode, and the cathode comprises a first cathode portion located in the transition region;
an isolation column, located on the side of the substrate and located in the transition region; and
a first film layer, in contact with the isolation column and located on a side that is of the isolation column and that faces the substrate, wherein
the isolation column comprises an insulation isolation portion, at least a part of a side wall of the insulation isolation portion is recessed toward an inside of the insulation isolation portion to form a groove, a surface of a side that is of the insulation isolation portion and that is away from the substrate is a first surface, and a surface, in contact with the first film layer, of a side that is of the insulation isolation portion and that faces the substrate is a second surface; and
the first cathode portion extending on the first film layer is separated at the groove from the first cathode portion extending on the first surface.

2. The display panel according to claim 1, wherein
the insulation isolation portion is of an integrated structure.

3. The display panel according to claim 2, wherein
the insulation isolation portion is an organic insulation layer.

4. The display panel according to claim 1, wherein
the isolation column further comprises a metal isolation portion, wherein the metal isolation portion is located at the groove; a surface, furthest away from the substrate, of a side that is of the metal isolation portion and that is away from the substrate is a third surface; and the insulation isolation portion covers the third surface.

5. The display panel according to claim 4, wherein
in a direction perpendicular to a plane on which the substrate is located, the groove comprises a first side and a second side that are opposite to each other; and
the metal isolation portion comprises a first metal portion and a second metal portion, the first metal portion is located on the first side of the groove, the second metal portion is located on the second side of the groove, and there is a spacing between the first metal portion and the second metal portion.

6. The display panel according to claim 5, wherein
the metal isolation portion further comprises a third metal portion, the third metal portion is located between the first metal portion and the second metal portion, and the first metal portion and the second metal portion separately protrude from the third metal portion in a direction away from the inside of the insulation isolation portion.

7. The display panel according to claim 4, wherein
the insulation isolation portion comprises two grooves that are opposite to each other, the isolation column comprises two metal isolation portions, and the two metal isolation portions are respectively located in the two grooves; and
the insulation isolation portion comprises a first insulation portion and a second insulation portion, the first insulation portion is located between the two metal isolation portions, the second insulation portion covers a side wall of the first insulation portion and a surface of a side that is of the first insulation portion and that is away from the substrate, and the second insulation portion further covers third surfaces of the two metal isolation portions.

8. The display panel according to claim 7, wherein
the first insulation portion is an organic insulation layer or an inorganic insulation layer, and the second insulation portion is an organic insulation layer or an inorganic insulation layer.

9. The display panel according to claim 1, wherein
the display panel further comprises a dam located in the transition region, and at least a part of the isolation columns are located on a side that is of the dam and that is close to the hole.

10. A manufacturing method for a display panel, comprising:
providing a substrate, wherein the substrate comprises a preset hole region, a transition region surrounding the preset hole region, and an image display region surrounding the transition region;
forming a first film layer in the preset hole region, the transition region, and the image display region of the substrate;
forming an isolation column on the first film layer, wherein the isolation column is located in the transition region, and the isolation column comprises an insulation isolation portion; and recessing at least a part of a side wall of the insulation isolation portion toward an inside of the insulation isolation portion to form a groove, wherein a surface of a side that is of the insulation isolation portion and that is away from the substrate is a first surface, and a surface that is of the insulation isolation portion and that is in contact with the first film layer is a second surface;
forming a display layer in the preset hole region, the transition region, and the image display region of the substrate, wherein the display layer comprises a cathode, the cathode comprises a first cathode portion located in the transition region, and the first cathode portion extending on the first film layer is separated at the groove from the first cathode portion extending on the first surface; and
cutting the substrate, the first film layer, and the display layer along an edge of the preset hole region to form a hole.

11. The manufacturing method according to claim 10, wherein
the transition region comprises a preset groove region, and after the forming a first film layer, the manufacturing method further comprises: forming a sacrificial metal portion on the first film layer, wherein the sacrificial metal portion is located in the preset groove region; and
a process of forming the insulation isolation portion on the first film layer, and recessing at least the part of the side wall of the insulation isolation portion toward the inside of the insulation isolation portion to form the groove comprises:
forming the insulation isolation portion on the first film layer, wherein the insulation isolation portion covers the sacrificial metal portion; and
removing the sacrificial metal portion, so that a side wall that is of the insulation isolation portion and that is in contact with the sacrificial metal portion form the groove.

12. An electronic device, comprising the display panel according to any one of claims 1 to 9.
